(19) Europäisches Patentamt
European Patent Office
Office européen des brevets

(11) **EP 4 750 284 A1**

(12) **EUROPEAN PATENT APPLICATION**
published in accordance with Art. 153(4) EPC

(43) Date of publication:
**27.05.2026 Bulletin 2026/22**

(21) Application number: **24843145.4**

(22) Date of filing: **17.07.2024**

(51) International Patent Classification (IPC):
**H10K 39/12** (2026.01)     **H10F 19/90** (2025.01)
**H10F 19/37** (2025.01)     **H10K 30/40** (2023.01)

(52) Cooperative Patent Classification (CPC):
Y02E 10/50

(86) International application number:
**PCT/JP2024/025579**

(87) International publication number:
**WO 2025/018356 (23.01.2025 Gazette 2025/04)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.07.2023 JP 2023117838**

(71) Applicant: **Panasonic Intellectual Property
Management Co., Ltd.
Kadoma-shi, Osaka 571-0057 (JP)**

(72) Inventors:
• **HIGUCHI, Hiroshi
Kadoma-shi, Osaka 571-0057 (JP)**

• **SHIRATAKI, Hiroshi
Kadoma-shi, Osaka 571-0057 (JP)**
• **UCHIDA, Ryusuke
Kadoma-shi, Osaka 571-0057 (JP)**
• **MATSUI, Taisuke
Kadoma-shi, Osaka 571-0057 (JP)**
• **HIRANO, Koichi
Kadoma-shi, Osaka 571-0057 (JP)**
• **KATAYAMA, Hirotaka
Kadoma-shi, Osaka 571-0057 (JP)**

(74) Representative: **Appelt, Christian W.
Boehmert & Boehmert
Anwaltspartnerschaft mbB
Pettenkoferstrasse 22
80336 München (DE)**

(54) **POWER GENERATION MODULE AND METHOD FOR MANUFACTURING POWER GENERATION MODULE**

(57)     A power generation module applicable to building-integrated photovoltaics is provided. The power generation module of the present disclosure is a power generation module comprising a plurality of submodules (101, 102, 103), the plurality of submodules (101, 102, 103) including a first submodule (101) and a second submodule (102) that are arranged adjacent to each other in plan view, the plurality of submodules (101, 102, 103) each comprising a base substrate and a power-generating section located on a portion of a main surface of the base substrate, the power-generating section having at least a photovoltaic layer supported on the main surface, wherein in plan view, the area ratio of the power-generating section to the main surface in the first submodule (101) is less than the area ratio of the power-generating section to the main surface in the second submodule (102).

EP 4 750 284 A1

## Fig. 7

**Description**

TECHNICAL FIELD

The present disclosure relates to a power generation module, particularly, a photovoltaic module that can be integrated with building materials.

BACKGROUND ART

Building-integrated photovoltaics (BIPV), which are integrated with building materials such as roofs, exterior walls, and windows of buildings, are attracting attention. For example, Patent Document 1 proposes a building material with a solar cell that can be used as a window.

PRIOR ART DOCUMENT

PATENT DOCUMENT

Patent Document 1: JP2020-84640A

SUMMARY OF INVENTION

TECHNICAL PROBLEM

There are a wide variety of requirements for building-integrated photovoltaics. For example, power generation modules applied to building-integrated photovoltaics may be required to have high design quality in addition to high power generation performance. They may also be required to be compatible with a variety of building materials with different functions, shapes, sizes, etc. However, with the structure of Patent Document 1, it may be difficult to design ones that meet these requirements.

An object of the present disclosure is to solve the above problem and to provide a power generation module that is applicable to building-integrated photovoltaics.

MEANS FOR SOLVING PROBLEM

A power generation module of the present disclosure is a power generation module including a plurality of submodules, the plurality of submodules including a first submodule and a second submodule arranged adjacent to each other in plan view,

wherein each of the plurality of submodules includes:

a base substrate; and
a power-generating section located on a portion of a main surface of the base substrate, the power-generating section including at least a photovoltaic layer supported on the main surface, and

wherein, in plan view, an area ratio of the power-generating section to the main surface in the first submodule is less than an area ratio of the power-generating section to the main surface in the second submodule.

A method for manufacturing a power generation module of the present disclosure is a method for manufacturing a power generation module including a plurality of submodules, the plurality of submodules including a first submodule and a second submodule, the method including:

forming the plurality of submodules; and
arranging the first submodule and the second submodule adjacent to each other,
wherein forming the plurality of submodules includes:

forming a laminated film including a photovoltaic film on a main surface of a base substrate; and
processing the laminated film to form a power-generating section including a photovoltaic layer on a part of the main surface,

wherein, in the processing of the laminated film, a portion of the photovoltaic film is removed from the main surface, and a remaining portion of the photovoltaic film forms the photovoltaic layer of the power-generating section, and wherein a ratio of an area of the photovoltaic film removed in the processing of the laminated film to an area of the main surface differs between the first submodule and the second submodule.

ADVANTAGEOUS EFFECT OF INVENTION

According to the present disclosure, a power generation module applicable to building-integrated photovoltaics can be provided.

BRIEF DESCRIPTION OF DRAWINGS

Fig. 1 is a schematic top view of a power generation module according to a first embodiment of the present disclosure.
Fig. 2 is a schematic cross-sectional view of the power generation module of Fig. 1 taken along line II-II.
Fig. 3 is a schematic exploded perspective view of the power generation module of Fig. 1.
Fig. 4 is a schematic top view of one submodule in the power generation module of Fig. 1.
Fig. 5 is an enlarged top view of a portion of the submodule of Fig. 4.
Fig. 6A is an enlarged cross-sectional view taken along line VIA-VIA in Fig. 5.
Fig. 6B is an enlarged cross-sectional view taken along line VIB-VIB in Fig. 5.
Fig. 7 is an enlarged top view showing a portion of the power generation module of Fig. 1.
Fig. 8 is a schematic top view showing another example of the power generation module according to the first embodiment.
Fig. 9A is a schematic process perspective view showing a film formation step in a method for manufacturing a submodule.
Fig. 9B is a schematic process perspective view showing a film formation step in the method for manufacturing the submodule.
Fig. 9C is a schematic process perspective view showing a film processing step in the method for manufacturing the submodule.
Fig. 9D is a schematic process cross-sectional view showing a film processing step in the method for manufacturing the submodule.
Fig. 9E is a schematic process perspective view showing a film processing step in the method for manufacturing the submodule.
Fig. 9F is a schematic process cross-sectional view showing a film processing step in the method for manufacturing the submodule.
Fig. 10A is a schematic process cross-sectional view showing a film processing step in the method for manufacturing the submodule.
Fig. 10B is a schematic process cross-sectional view showing a film processing step in the method for manufacturing the submodule.
Fig. 10C is a schematic process cross-sectional view showing a film processing step in the method for manufacturing the submodule.
Fig. 11 is a schematic top view showing a wiring formation step in the method for manufacturing the submodule.
Fig. 12A is a schematic process top view showing a submodule arrangement step in the method for manufacturing the power generation module of Fig. 1.
Fig. 12B is a schematic process top view showing a submodule arrangement step in the method for manufacturing the power generation module of Fig. 1.
Fig. 13A is a schematic process cross-sectional view showing a sealing step in the method for manufacturing the power generation module of Fig. 1.
Fig. 13B is a schematic process cross-sectional view showing a sealing step in the method for manufacturing the power generation module of Fig. 1.
Fig. 13C is a schematic process cross-sectional view showing a sealing step in the method for manufacturing the power generation module of Fig. 1.
Fig. 14 is a schematic diagram illustrating the relationship between the photovoltaic film removal area ratio and the power-generating section area ratio of the submodule and the light transmittance.
Fig. 15 is a flowchart illustrating a method for setting the light transmittance of the submodule.
Fig. 16 is a schematic enlarged top view showing an example of a string structure.
Fig. 17 is a schematic enlarged top view showing another example of the string structure.

Fig. 18 is a schematic enlarged top view showing yet another example of the string structure.

Fig. 19A is an enlarged top view showing another example of the submodule.

Fig. 19B is an enlarged top view showing another example of the submodule.

Fig. 20 is an enlarged top view showing one submodule in a second embodiment of the present disclosure.

Fig. 21 is a schematic enlarged top view showing an example of the string structure.

Fig. 22 is a schematic enlarged top view showing another example of the string structure.

Fig. 23 is a schematic enlarged top view showing yet another example of the string structure.

Fig. 24 is an enlarged top view of one submodule for explaining a design example of varying the string width and the inter-string region width.

Fig. 25 is a schematic top view showing an example of gradation of a module column.

Fig. 26 is a schematic top view showing another example of gradation of the module column.

Fig. 27 is a schematic diagram for explaining the relationship between the distance along the Y direction from the upper end of a first submodule and the string area ratio and light transmittance in the power generation modules of the first and second embodiments.

Fig. 28A is a schematic process cross-sectional view showing a film processing step in a method for manufacturing a submodule having gradation.

Fig. 28B is a schematic process cross-sectional view showing a film processing step in the method for manufacturing the submodule having gradation.

Fig. 28C is a schematic process cross-sectional view showing a film processing step in the method for manufacturing the submodule having gradation.

Fig. 29A is a schematic process cross-sectional view showing another film processing step in the method for manufacturing the submodule having gradation.

Fig. 29B is a schematic process cross-sectional view showing another film formation step in the method for manufacturing the submodule having gradation.

Fig. 29C is a schematic process cross-sectional view showing another film processing step in the method for manufacturing the submodule having gradation.

DESCRIPTION OF EMBODIMENTS

Embodiments of the present disclosure will now be described with reference to the drawings. Note that the present disclosure is not limited by these embodiments. In addition, substantially identical components in the drawings are denoted by the same reference numerals. For illustrative purposes, the dimensions of each element in the drawings may be exaggerated and are not necessarily drawn to scale. For reference, the drawings schematically show mutually orthogonal X-, Y-, and Z-axes.

In the following, for convenience of explanation, terms indicating directions such as "up," "down," "right," "left," and "side" are used assuming a state during normal use, but are not intended to limit the state of use of the power generation module according to the present disclosure. Furthermore, in this specification, "orthogonal" means within a range of $90° \pm 10°$. "Parallel" means within a range of, for example, $\pm 5°$.

In the drawings described below, for reference, the mutually orthogonal X-axis, Y-axis, and Z-axis are schematically depicted. In the following description, when simply written as the X-direction, Y-direction, or Z-direction, it refers to the respective axial direction, and includes two opposite directions (for example, the -X-direction and the +X-direction).

«First Embodiment»

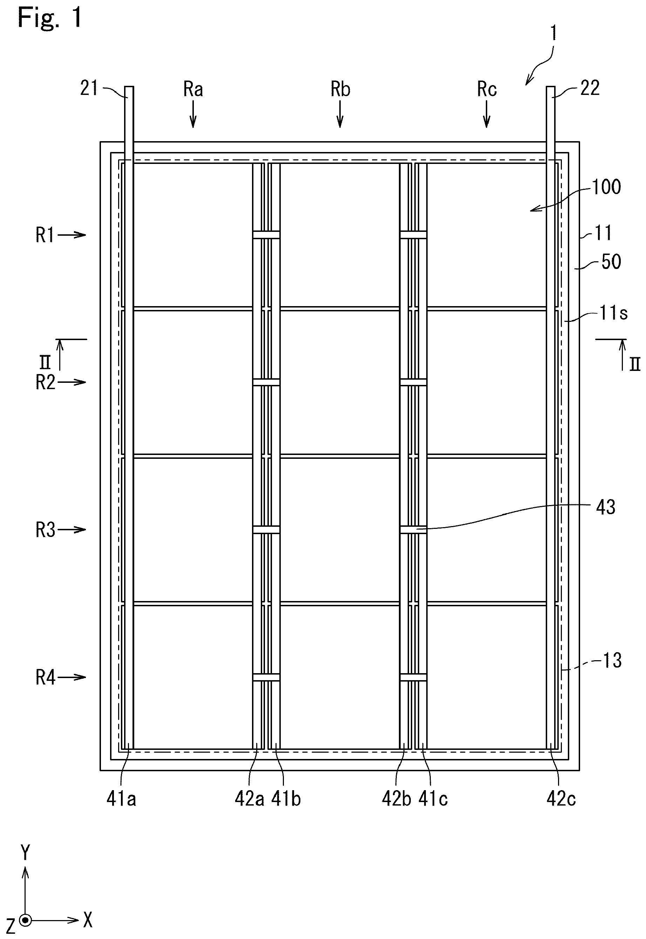

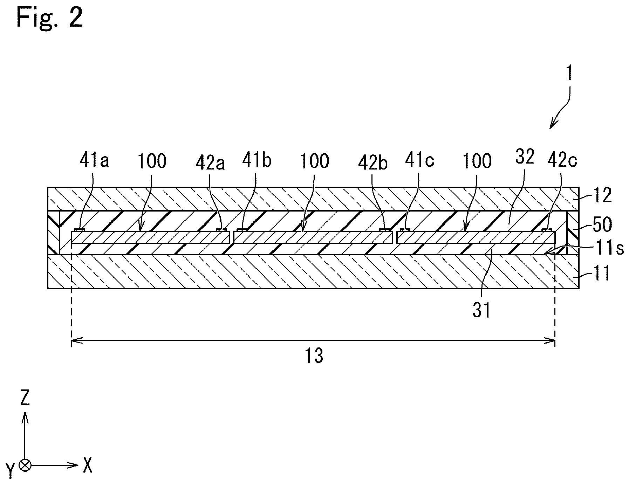

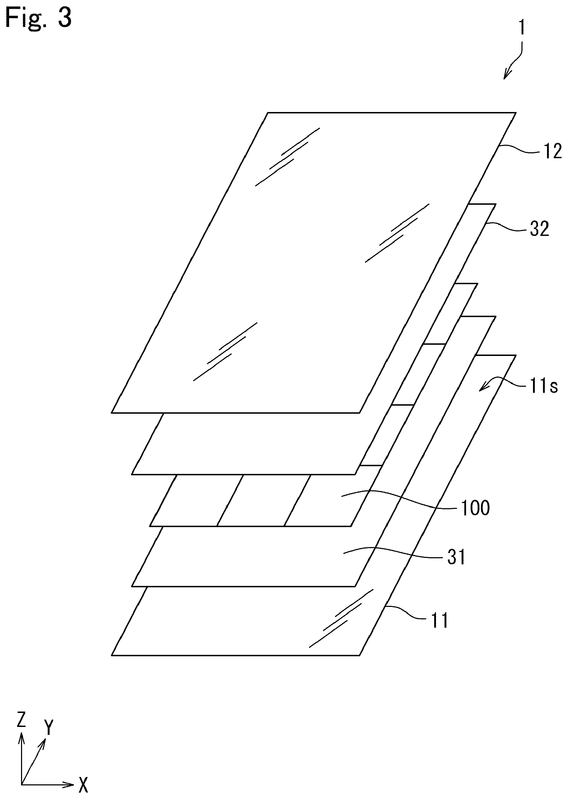

The basic configuration of a power generation module according to a first embodiment of the present disclosure will be described with reference to Figs. 1 to 3. Fig. 1 is a schematic top view of the power generation module according to the embodiment of the present disclosure. Fig. 2 is a schematic cross-sectional view of the power generation module of Fig. 1 taken along line II-II. Fig. 3 is a schematic exploded perspective view of the power generation module of Fig. 1.

As shown in Figs. 1 to 3, a power generation module 1 includes a first substrate 11, a second substrate 12, a plurality of submodules 100, a first filler 31, and a second filler 32.

In the following description, the power generation module 1 will be described as a power generation module that can be integrated with building materials such as windows of a building. The power generation module 1 can be used, for example, as a window that is arranged in a building so that external light enters from the second substrate 12 side.

The Z-direction (also referred to as the "first direction") shown in Figs. 1 to 3 corresponds to the thickness direction of the power generation module 1. The thickness direction of the power generation module 1 is, for example, the stacking direction of the two substrates 11, 12, or the stacking direction of the photovoltaic layers included in the power generation module 1. In addition, directions that intersect with each other (here, orthogonal) in a plane orthogonal to the Z-direction are defined as the X-direction and the Y-direction. The Y-direction may be, for example, the height direction of the window, and the X-direction may be, for example, the width direction of the window.

The first substrate 11 and the second substrate 12 have light-transmitting properties. "Light-transmitting properties" refers to transmissivity for visible light. "Have light-transmitting properties" means, for example, that the transmittance of visible light is 50% or more, preferably 70% or more. The first substrate 11 and the second substrate 12 are, for example, rectangular glass substrates (tempered glass substrates). As shown in Fig. 1, in the top view of the power generation module 1 or a portion thereof, the second substrate 12 may be omitted for clarity.

As shown in Fig. 2, the first substrate 11 and the second substrate 12 are disposed to face each other in the Z-direction. The second substrate 12, which is the light-receiving side, may be thinner than the first substrate 11. The peripheral edges of the first substrate 11 and the second substrate 12 are sealed by a sealing member 50. In a plan view seen along the Z-direction, the sealing member 50 is located outward of a central region 13 of the first substrate 11 in which the submodules 100 are arranged. The sealing member 50 can be made of a thermoplastic elastomer such as butyl rubber.

Each of the plural submodules 100 is a solar cell submodule having a solar cell (power-generating section). The plural submodules 100 are located between the first substrate 11 and the second substrate 12. Each submodule 100 has, for example, a rectangular planar shape. In the example shown in Fig. 1, the submodule 100 is disposed in a space surrounded by the first substrate 11, the second substrate 12, and the sealing member 50. The plural submodules 100 are disposed in the central region 13 of the first substrate 11 so as not to overlap each other in plan view seen along the Z-direction.

As shown in Fig. 2, the first filler 31 is located between the first substrate 11 and the lower surface of each submodule 100. The second filler 32 is located between the second substrate 12 and the upper surface of each submodule 100. These fillers 31 and 32 may be made of, for example, polyolefin (PO).

The fillers 31 and 32 may fill the space surrounded by the first substrate 11, the second substrate 12, and the sealing member 50. This can suppress the influence of air on the photovoltaic layer in the submodule 100. An air layer may be partially formed in the space. In this example, the fillers 31 and 32 are arranged above and below the submodule 100, but they may be arranged on only one side.

In this embodiment, the submodules 100 are arranged in a matrix in two directions (here, the X-direction and the Y-direction) that intersect (here, are orthogonal to) each other in plan view along the Z-direction. Columns Ra to Rc each consisting of a plurality of submodules arranged in the Y-direction are called "module columns." Rows R1 to R4 each consisting of a plurality of submodules arranged in the X-direction are called "module rows."

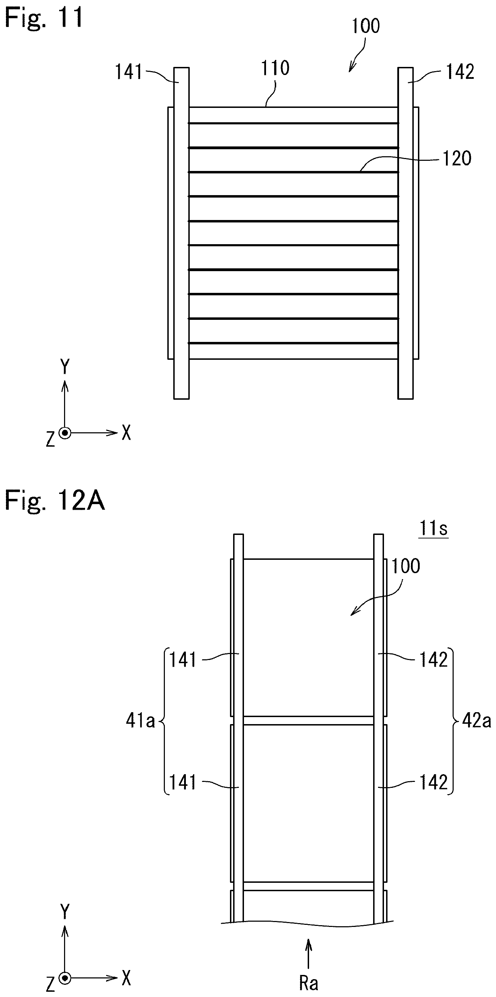

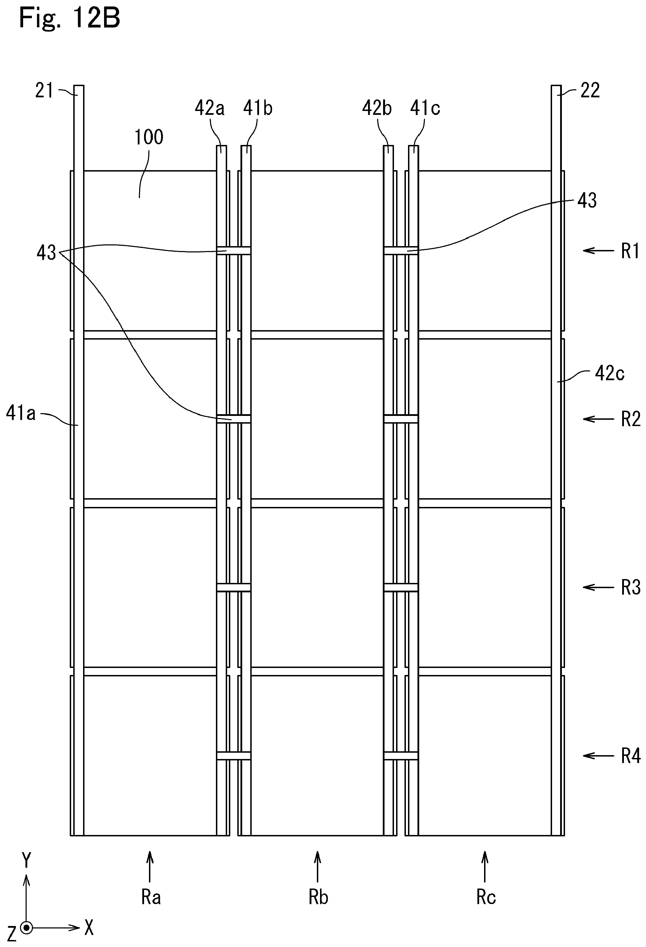

In the example shown in Fig. 1, 12 submodules 100 are arranged in four rows and three columns, constituting the four module rows R1 to R4 and the three module columns Ra to Rc. The plural (four in this example) submodules constituting each module column Ra to Rc are connected in parallel. The three module columns Ra to Rc are connected in series in the X-direction.

As shown in Fig. 1, the power generation module 1 further includes first wirings 41a to 41c and second wirings 42a to 42c extending in the Y-direction between the first substrate 11 and the second substrate 12, and a plurality of third wirings 43 for connecting adjacent first wirings and second wirings. These wirings may be metal wirings. In this embodiment, these wirings are wires (tab wires) made of copper wires coated with solder.

The first wiring 41a and the second wiring 42a connect the plural (four in this example) submodules 100 that make up the module column Ra in parallel. Similarly, the first wirings 41b, 41c and the second wirings 42b, 42c connect the plural submodules 100 that make up the module columns Rb, Rc in parallel. In the example shown, the first wirings 41a to 41c are arranged at one end of each of the module columns Ra to Rc in the X-direction. The second wirings (e.g., tab wires) 42a to 42c are arranged at the other end of each of the module columns Ra to Rc in the X-direction.

The plurality of third wirings 43 connects two adjacent module columns in series among the three module columns Ra to Rc, and are arranged so as to connect the first wiring of one of the two adjacent module columns to the second wiring of the other module column.

As shown in Fig. 1, the power generation module 1 further includes a pair of lead wires (positive and negative lead wires) 21, 22. The lead wires 21, 22 are, for example, metal wiring (e.g., tab wires). The lead wires 21, 22 are electrically connected to the submodules 100 within a space surrounded by the first substrate 11, the second substrate 12, and the sealing member 50. The lead wires 21, 22 may be drawn from within the space to the outside, passing through the sealing member 50.

In the example shown in Fig. 1, the lead wire 21 is electrically connected to one end of the first wiring 41a of the leftmost module column Ra. The lead wire 22 is electrically connected to one end of the second wiring 42c of the rightmost module column Rc. The lead wire 21 may be an extended portion of the first wiring 41a, and the lead wire 22 may be an extended portion of the second wiring 42c.

(Structure of Submodule 100)

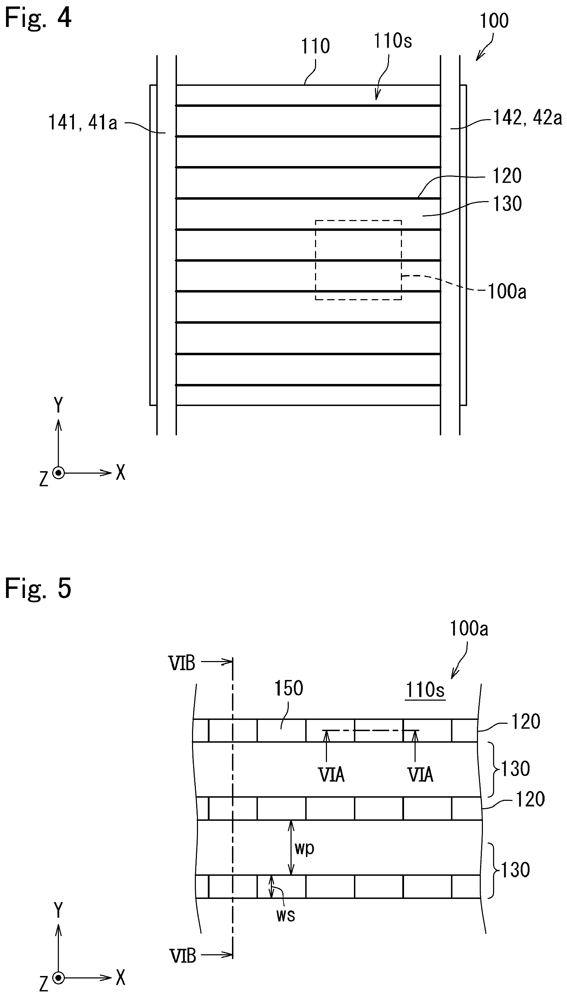

Referring to Figs. 4 to 6B, the structure of the submodule 100 in the power generation module 1 will be described. Here, one submodule in the module column Ra (Fig. 1) will be described as an example.

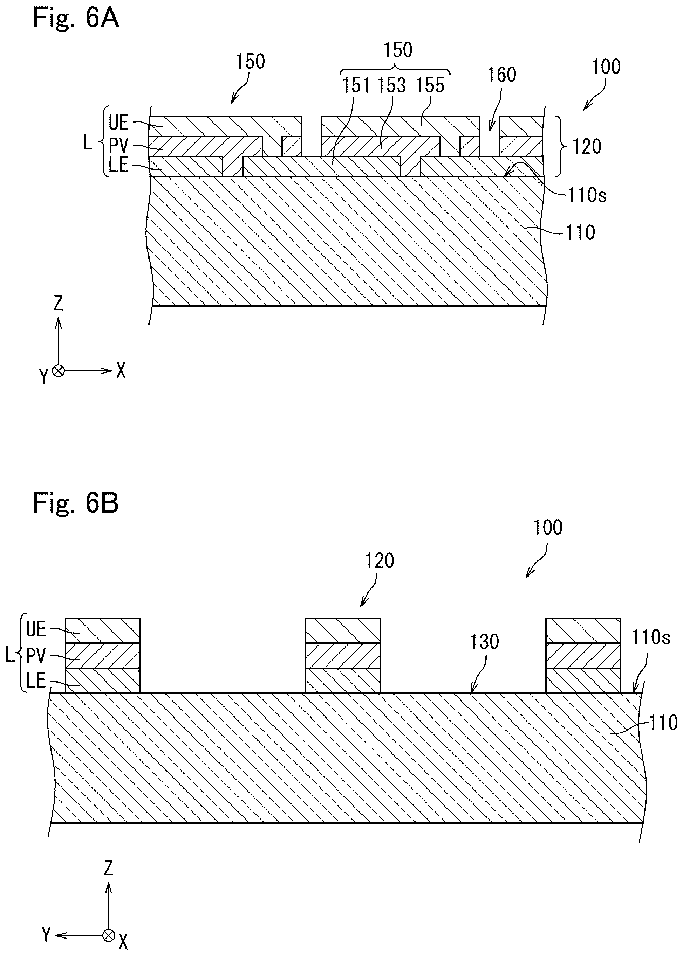

Fig. 4 is a schematic top view of one submodule in the power generation module. Fig. 5 is an enlarged top view of a portion of the submodule in Fig. 4. Fig. 5 shows an enlarged view of a region 100a shown in Fig. 4. Fig. 6A is an enlarged cross-sectional view taken along line VIA-VIA in Fig. 5. Fig. 6B is an enlarged cross-sectional view taken along line VIB-VIB in Fig. 5.

As shown in Fig. 4, each submodule 100 includes a base substrate 110 having light-transmitting properties, a power-generating section supported by the base substrate 110, and a pair of wirings 141, 142. In the example shown in Fig. 4, the power-generating section includes a plurality of linear strings 120.

The base substrate 110 is, for example, a rectangular glass substrate. The power-generating section is located on a part of a main surface 110s of the base substrate 110.

The power-generating section includes at least a photovoltaic layer. As described below, the power-generating section has a stacked structure including at least a pair of transparent electrodes and a photovoltaic layer located between the pair of transparent electrodes. The stacked structure only needs to be supported by the main surface 110s of the base substrate 110, and does not need to be in direct contact with the main surface 110s.

The wiring 141 is arranged on one end side of the base substrate 110. The wiring 142 is arranged on the other end side of the base substrate 110. In this example, the wirings 141, 142 are arranged at both ends of the base substrate 110 in the X-direction. The wirings 141, 142 are electrically connected to the power-generating section. The wirings 141, 142 are connected to the wirings 141, 142 of other submodules (not shown) adjacent in the Y-direction, respectively, to form the first wiring 41a and the second wiring 42a.

The plurality of strings 120, which are power-generating sections, are connected in parallel by the wirings 141, 142. Here, each string 120 extends in the X-direction from one end to the other end of the base substrate 110. One end of each string 120 is connected to the wiring 141, and the other end is connected to wiring 142.

The plural strings 120 are arranged on the main surface 110s of the base substrate 110 at a distance from each other in the Y-direction. In plan view seen along the Z-direction, the plural strings 120 may extend parallel to each other, for example. In plan view seen along the Z-direction, regions 130 of the main surface 110s of the base substrate 110 located between adjacent strings 120 are referred to as "inter-string regions."

As shown in Figs. 5 and 6, each of the plurality of strings 120 is a solar cell element string having a plurality of solar cell elements 150 connected in series.

As shown in Figs. 6A and 6B, each string 120 has a stacked structure L in the Z-direction, including a lower transparent conductive layer LE, a photovoltaic layer PV, and an upper transparent conductive layer UE. These layers are supported by the main surface 110s. In the stacked structure L, the photovoltaic layer PV is located between the lower transparent conductive layer LE and the upper transparent conductive layer UE. The lower transparent conductive layer LE is located on the base substrate 110 side of the photovoltaic layer PV. The photovoltaic layer PV may further include an electron transport layer and/or a hole transport layer as necessary. The photovoltaic layer PV is, for example, a laminated film including, from the base substrate 110 side, an n-type semiconductor layer, an i-type semiconductor layer, and a p-type semiconductor layer.

The lower transparent conductive layer LE, photovoltaic layer PV, and upper transparent conductive layer UE are separated for each solar cell element 150. In this example, the photovoltaic layer PV and the upper transparent conductive layer UE are separated for each solar cell element 150 by a separation groove 160. The lower transparent conductive layer LE includes a lower transparent electrode 151 of each solar cell element 150. The upper transparent conductive layer UE includes an upper transparent electrode 155 of each solar cell element 150. The photovoltaic layer PV includes a semiconductor layer 153 of each solar cell element 150.

Each solar cell element 150 has the lower transparent electrode 151, the upper transparent electrode 155, and the semiconductor layer 153 located between the lower transparent electrode 151 and the upper transparent electrode 155. The lower transparent electrode 151 (or the upper transparent electrode 155) of the solar cell element 150 located at one end of each string 120 is electrically connected to the wiring 141. Similarly, the upper transparent electrode 155 (or the lower transparent electrode 151) of the solar cell element 150 located at the other end of each string 120 is electrically connected to the wiring 142.

The photovoltaic layer PV (i.e., the semiconductor layer 153) is a layer (photoelectric conversion layer) that converts absorbed light into electricity. The photovoltaic layer PV includes, for example, a perovskite compound (perovskite semiconductor) as a photoelectric conversion material. The perovskite compound is a perovskite crystal structure represented by the chemical formula $ABX_3$ or a structure having a crystal similar thereto. A is a monovalent cation, B is a divalent cation, and X is a halogen anion. The lower transparent conductive layer LE and the upper transparent conductive layer UE are, for example, metal oxide layers having light-transmitting properties such as indium tin oxide (ITO), indium zinc oxide (IZO), or fluorine-doped tin oxide (FTO) layers. Note that the materials of each layer constituting the solar cell element are not limited to those described above, and known materials may be used.

(Power-Generating Section Area Ratio of Submodule 100)

Reference is made again to Figs. 4 and 5. In this specification, the ratio of the area of the power-generating section to the area of the main surface 110s of the base substrate 110 in plan view along the Z-direction is referred to as the "power-generating section area ratio." In the example shown in Fig. 4, the "area of the power-generating section" is the total area of the plural strings 120 in plan view along the Z-direction. The power-generating section area ratio is, for example, substantially equal to the ratio of the area of the portion where the photovoltaic layer PV (or photovoltaic film) is present to the area of the main surface 110s in plan view along the Z-direction (hereinafter referred to as the "photovoltaic layer area ratio"). Hence, the power-generating section area ratio can also be said to be the photovoltaic layer area ratio.

In the submodule 100, the light transmittance of the power-generating section for visible light incident in the Z-direction is lower than the light transmittance of the portion where the power-generating section is not formed. This is because the power-generating section includes a photovoltaic layer PV, which has a lower visible light transmittance than, for example, a glass substrate. Thus, by changing the power-generating section area ratio, it is possible to adjust the light transmittance of the entire submodule 100. Note that in this specification, "light transmittance" refers to the transmittance (visible light transmittance) for visible light (wavelength 400 nm to 700 nm) incident on the power generation module 1 along the first direction (Z-direction).

In the example shown in Fig. 5, the power-generating section area ratio can be adjusted by the number of strings 120 arranged in the submodule 100, the width of each string 120 along the second direction (hereinafter referred to as the "string width") ws, the distance (hereinafter referred to as the "inter-string distance") between two adjacent strings 120 along the second direction (Y-direction), and the like. The inter-string distance refers to the width (hereinafter referred to as the "inter-string region width") wp of an inter-string region 130 along the second direction. As an example, the power-generating section area ratio of each submodule 100 can be appropriately selected within a range of, for example, 20 to 80%. This allows the light transmittance of each submodule 100 to be adjusted to a desired value within a range of, for example, 20 to 80%.

(Arrangement of Submodules in Power Generation Module)

The power generation module 1 of this embodiment includes two submodules adjacent in the second direction when viewed in plan view from the first direction (Z-direction). The two adjacent submodules are configured to have different power-generating section area ratios. In this specification, the submodule with the smaller power-generating section area ratio may be referred to as the "first submodule," and the submodule with the larger power-generating section area ratio may be referred to as the "second submodule." The first submodule may have a higher light transmittance than the second submodule.

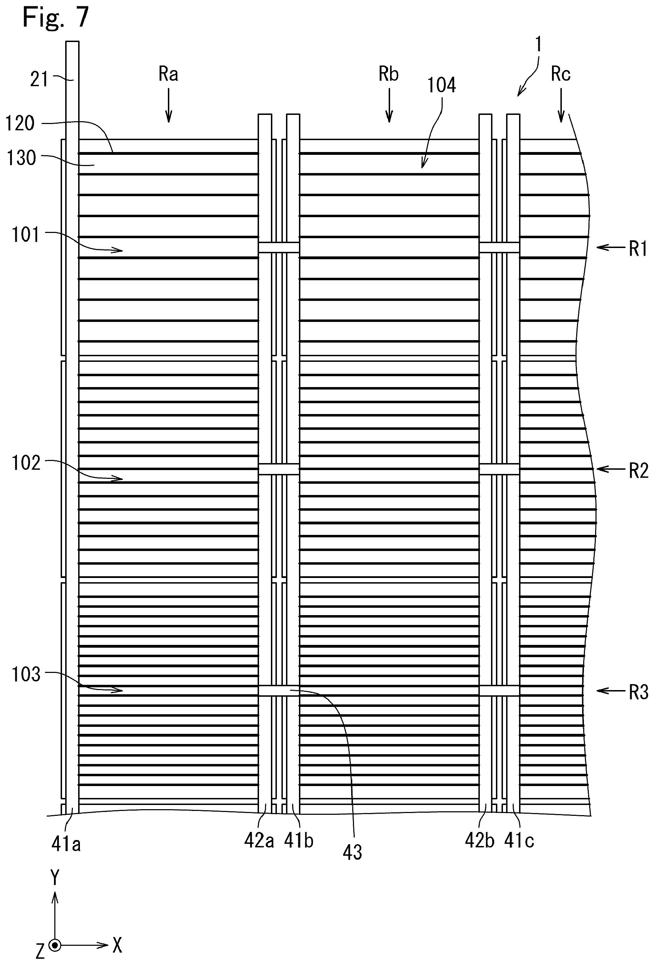

Fig. 7 is an enlarged top view showing a part of the power generation module of Fig. 1. Fig. 7 shows an enlarged view of submodules 100 belonging to three rows and three columns located in the upper left corner, of the submodules 100 shown in Fig. 1.

Description will be given using as an example two submodules 101 and 102 in the module column Ra shown in Fig. 7. The submodules 101 and 102 are adjacent to each other in the second direction (here, the Y-direction) in plan view seen from the first direction (the Z-direction). In this example, the submodules 101 and 102 are connected in parallel to each other.

The power-generating section area ratio of the submodule 101 is smaller than the power-generating section area ratio of the submodule 102. That is, in this example, the submodule 101 corresponds to the "first submodule" and the submodule 102 corresponds to the "second submodule." This allows the light transmittance of the submodule 101 to be greater than the light transmittance of the submodule 102.

In the example shown in Fig. 7, the strings 120 are arranged at equal intervals in the Y-direction in each of the submodules 101 and 102. The strings 120 are arranged more densely in the submodule 102 than in the submodule 101. Therefore, the number of the strings 120 in the submodule 102 is greater than the number of the strings 120 in the submodule 101. The width of the strings 120 in the Y-direction is, for example, all constant. In this way, the power-generating section area ratio of the submodule 102 (here, the ratio of the total area of the strings 120 to the main surface 110s) can be set to be greater than that of the submodule 101.

The power generation module 1 further includes a submodule 103 arranged on the side of the submodule 102 opposite to the submodule 101 in the second direction (here, the Y-direction) in plan view seen along the Z-direction. The submodule 103 may be referred to as a "third submodule." The power-generating section area ratio of the submodule 102 is smaller than the power-generating section area ratio of the submodule 103. In this example, the strings 120 are arranged more densely in the submodule 103 than in the submodule 102.

As illustrated in Fig. 7, the submodules 100 constituting each of the module columns Ra to Rc may be configured so that the power-generating section area ratio decreases as the submodule approaches one end of the module column (here, the upper end (+Y side)). This allows the light transmittance to be changed along the Y-direction (e.g., the height direction of the window).

The power generation module 1 further includes a submodule 104 arranged adjacent to the submodule 101 in a third direction (here, the X-direction) intersecting the second direction in plan view along the Z-direction. The submodule 104 may be referred to as "fourth submodule." The power-generating section area ratio of the submodule 104 is equal to the power-generating section area ratio of the submodule 101. In this example, the number of the strings 120 of the submodule 104 is the same as that of the first submodule 101.

As illustrated in Fig. 7, the submodules 100 constituting each of the module rows R1 to R4 may all be configured to have the same power-generating section area ratio. This makes it possible to maintain a constant transmittance along the X-direction (e.g., the width direction of the window).

(Another Example of Submodule Arrangement)

The power generation module of this embodiment may include at least two submodules adjacent to each other in the second direction and having different power-generating section area ratios. In Fig. 7, the first submodule is located above (on the +Y side of) the second submodule, but it may also be located below (on the -Y side of) it. Also, in Fig. 7, the second direction is described as the Y-direction, but the second direction may be any direction (any direction on the XY plane) that intersects with the first direction, which is the thickness direction of the power generation module 1. The number and arrangement of the submodules are not limited to the example shown in Fig. 7. In Fig. 7, the submodules 100 are arranged in a matrix, but the submodules 100 may also be arranged in only one direction.

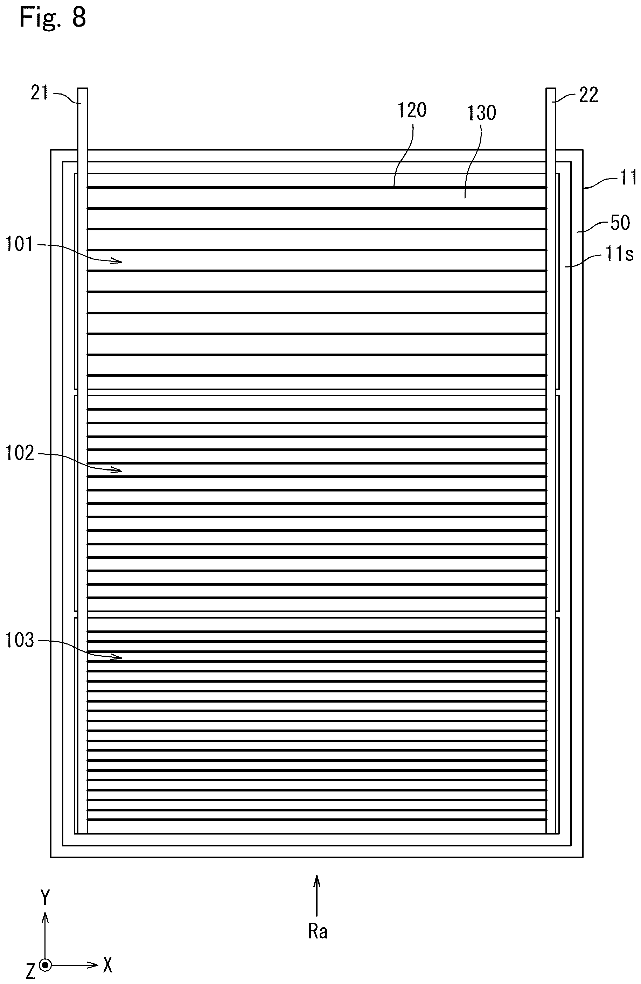

Fig. 8 is a schematic top view showing another example of the power generation module of the first embodiment.

The power generation module shown in Fig. 8 differs from the configuration shown in Fig. 2 in that it includes a single module column including a plurality of (here, three) submodules 101 to 103.

Similar to the submodules 101 to 103 shown in Fig. 7, the submodules 101 to 103 are configured such that the submodules located closer to one end of the module column Ra (here, the +Y side) have a higher power-generating section area ratio. Therefore, the light transmittance of the power generation module gradually increases in the +Y-direction. As shown in the figure, depending on, for example, the size of the window, the planar shape of each of the submodules 101 to 103 may be a rectangle elongated in the X-direction. This configuration makes it possible to provide a power generation module that is simple and has an excellent appearance, without the need to arrange wiring between the submodules.

(Submodule Manufacturing Method)

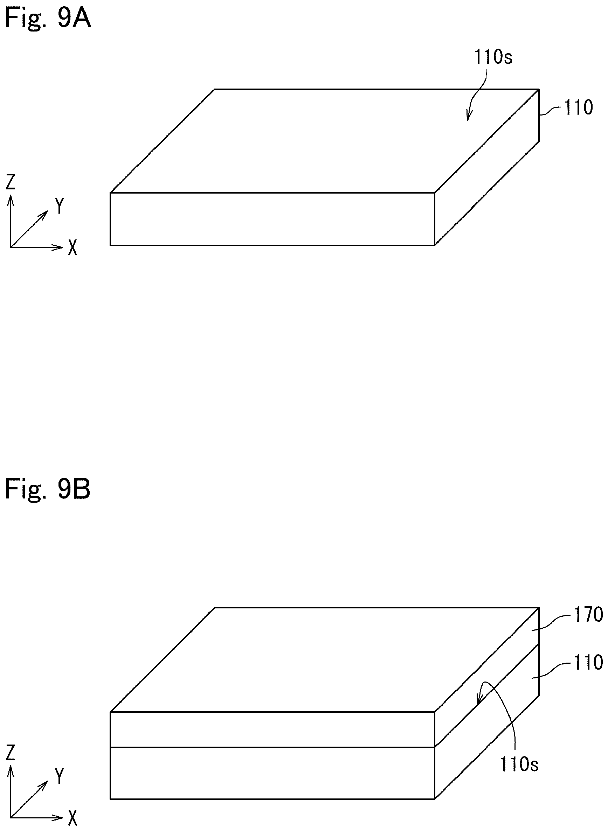

A method for manufacturing the submodule 100 will be described with reference to Figs. 9A to 11.

The manufacturing method of the submodule 100 includes a film formation step in which the laminated film including a photovoltaic film is formed on the main surface of the base substrate, a film processing step in which the laminated film is processed to form a power-generating section, and a wiring formation step in which wiring is arranged to electrically connect to the power-generating section.

·Film Formation Step

Figs. 9A and 9B are each a schematic process perspective view for explaining the film formation step.

First, as shown in Fig. 9A, the base substrate 110 having light-transmitting properties is prepared. In this example, a glass substrate is prepared as the base substrate 110. Alternatively, a substrate whose surface is covered with a transparent conductive film, such as an FTO substrate, may be used.

Next, as shown in Fig. 9B, a laminated film 170 including a lower transparent conductive film, a photovoltaic film, and an upper transparent conductive film in this order from the main surface 110s side of the base substrate 110 is formed on the main surface 110s.

Each film in the laminated film 170 is formed by a known method and patterned as necessary. For example, patterning of the lower transparent conductive film, formation of a contact portion connecting the upper transparent conductive film and the lower transparent conductive film, etc. may be performed as appropriate. When a substrate whose surface is covered with a transparent conductive film, such as an FTO substrate, is used, the transparent conductive film on the substrate surface may be used as the lower transparent conductive film in the laminated film 170.

The photovoltaic film includes, for example, a perovskite compound. The photovoltaic film is applied onto the lower transparent conductive film formed on the main surface 110s by a method such as spin coating or inkjet printing. The photovoltaic film is, for example, a laminated film including an n-type semiconductor film, an i-type semiconductor film (perovskite layer), and a p-type semiconductor film. First, the n-type semiconductor film is applied using an inkjet printing method and dried, and then the i-type semiconductor film that will become the upper layer is applied using an inkjet printing method and dried. Similarly, the p-type semiconductor film is applied using an inkjet printing method and dried to form a laminated film. The laminated film that will become the photovoltaic film may be formed by repeating the application and drying in this manner.

·Film Processing Step

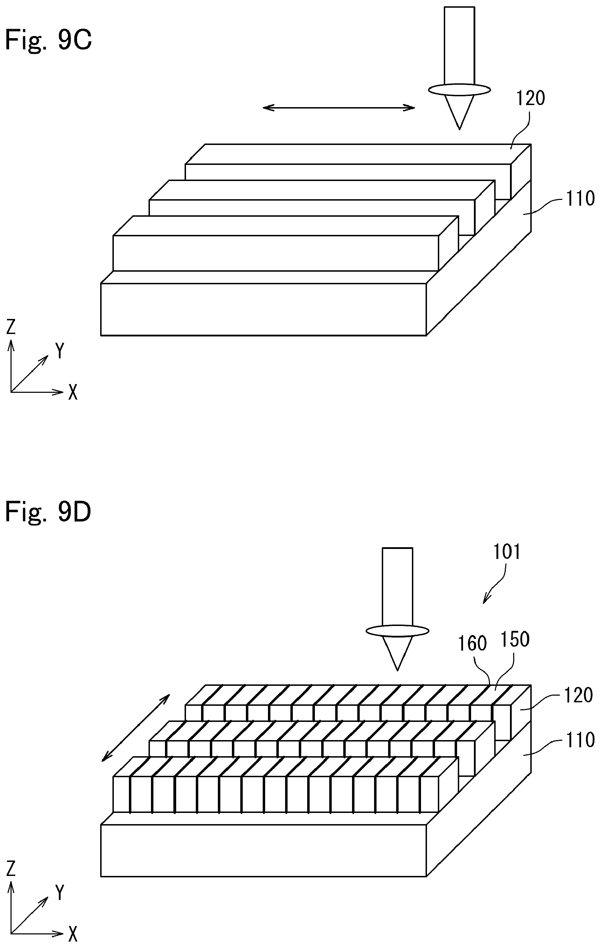

In the film processing step, first, as shown in Fig. 9C, a laser beam is scanned in the X-direction to perform a first laser processing step (string formation step) on the laminated film 170 formed by the above method, and a portion of the laminated film 170 is removed from the main surface 110s. Here, a scribing process such as laser scribing is performed. The portion of the laminated film 170 that is not removed and remains on the main surface 110s becomes the power-generating section (string 120).

Next, as shown in Fig. 9D, a second laser processing step (element separation step) is performed by scanning a laser beam in the Y-direction. As a result, a plurality of separation grooves 160 (corresponding to the separation grooves 160 in Fig. 6A) extending in the Y-direction are formed in each string 120, separating the string into the plurality of solar cell elements 150. In this way, the stacked structure L illustrated in Fig. 6A is obtained.

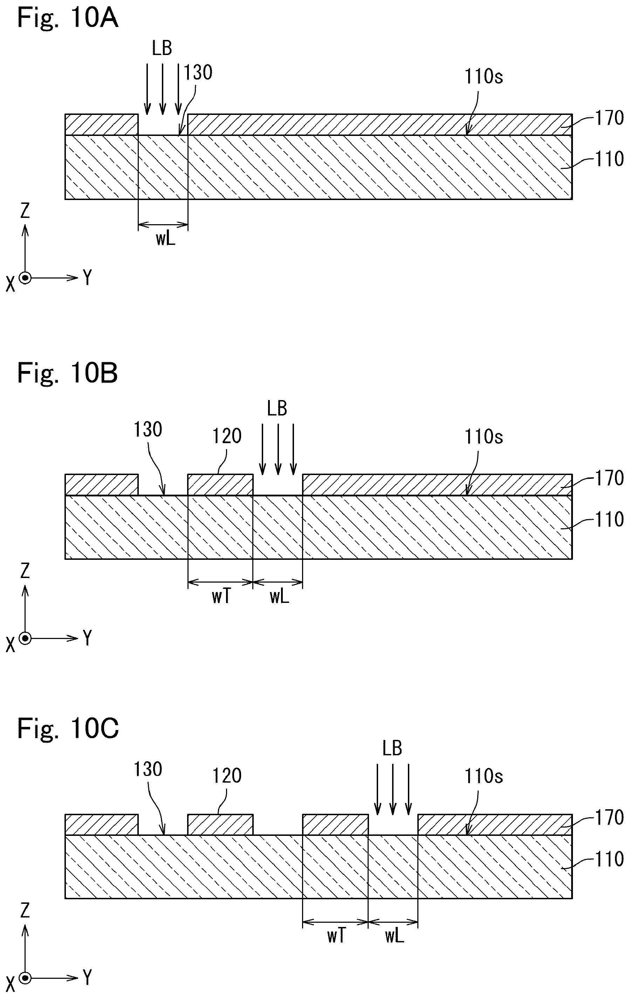

The first laser processing step (Fig. 9C) will be described in more detail below with reference to Figs. 10A to 10C. Here, an example will be described in which the lower transparent conductive film, photovoltaic film, and upper transparent conductive film constituting the laminated film 170 are all removed simultaneously by laser processing. It is sufficient that at least a portion of the photovoltaic film is removed from the base substrate by laser processing. The other transparent conductive films may be processed by a method different from that for the photovoltaic film and may have a different pattern.

Figs. 10A to 10C are schematic process cross-sectional views illustrating the film processing step.

As shown in Fig. 10A, the laser beam LB is scanned in the X-direction to irradiate the laminated film 170 with the laser beam LB over a predetermined irradiation range (referred to as the "irradiation width") wL. This removes the irradiated portion of the laminated film 170. The removed portion becomes a linear region (inter-string region) 130 extending in the X-direction. If the irradiation width wL is wide, plural scans may be performed to irradiate the predetermined range wL. In this example, the laminated film 170 is removed throughout the thickness direction, exposing a portion of the main surface 110s.

Next, as shown in Fig. 10B, the laser head is moved to shift the irradiation position of the laser beam LB in the Y-direction by a predetermined distance (referred to as the "non-irradiation width") wT. In this state, the laser beam LB is scanned in the X-direction to irradiate the laminated film 170 with the laser at an irradiation width wL, thereby removing a portion of the laminated film 170. Between two removed portions adjacent in the Y-direction, a line-shaped stacked structure, i.e., the string 120, having the same width as the non-irradiation width wT is formed. As shown in Fig. 10C, the laminated film 170 is then irradiated with the laser while continuing to shift the irradiation position in the Y-direction. In this manner, the plurality of strings 120 can be formed on the main surface 110s, equally spaced in the Y-direction.

In this embodiment, in the film processing step, a first submodule (e.g., submodule 101 in Fig. 7) and a second submodule (e.g., submodule 102 in Fig. 7) are fabricated by varying the processing conditions in the first laser processing step. This allows the removal area (total area) of the photovoltaic film to be different, making it possible to separately fabricate two submodules with different light transmittances.

The irradiation width wL and non-irradiation width wT of the laser beam LB can be appropriately set so as to obtain a desired light transmittance and power generation amount. For example, the irradiation width wL1 of the laser beam LB when manufacturing the first submodule may be larger than the irradiation width wL2 when manufacturing the second submodule. Alternatively, the non-irradiation width wT1 when manufacturing the first submodule may be smaller than the non-irradiation width wT2 when manufacturing the second submodule. An example of a method for separately fabricating the submodules 101 and 102 will be described with reference to Figs. 9A to 9F.

First, a plurality of base substrates 110 smaller in size than the first substrate 11 are prepared (Fig. 9A). The laminated film 170 is formed on the main surface 110s of each of these substrates 110 under the same lamination conditions, and a plurality of base submodules (hereinafter, "base submodules with laminated film") are prepared (Fig. 9B).

Next, as shown in Fig. 9C, the base submodule with the laminated film is subjected to the first laser processing step (string formation step) under first processing conditions (irradiation width wL1 and non-irradiation width wT1). This forms the plurality of strings 120 on the base substrate 110, each with a string width wT1 and an inter-string distance wL1. Next, as shown in Fig. 9D, a second laser processing step (element separation step) is performed to form a submodule. This becomes the "first submodule 101."

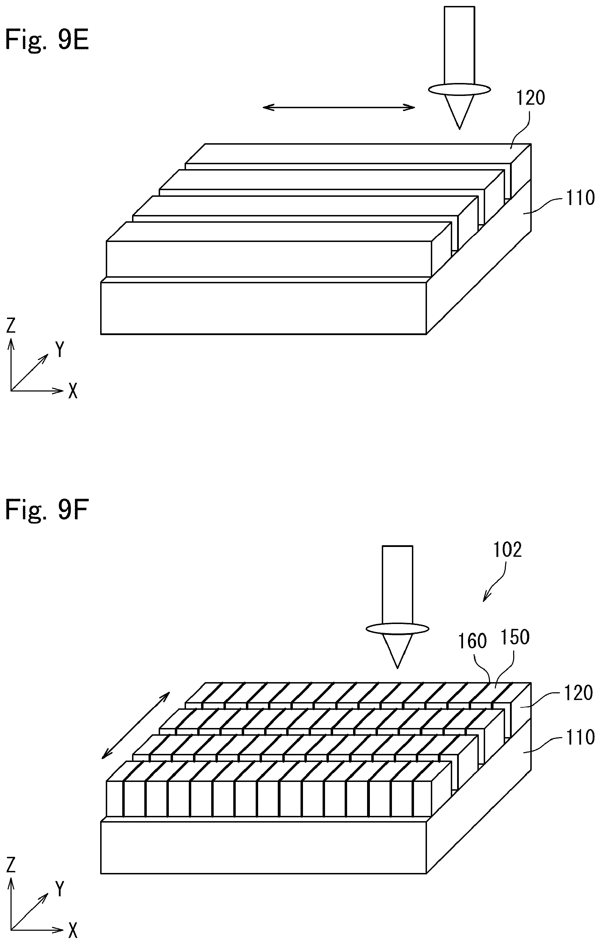

Similarly, as shown in Fig. 9E, the base submodule with the laminated film (Fig. 9B) is processed under second processing conditions (irradiation width wL2 (wL2<wL1), non-irradiation width wT2 (wT2=wT1)) that are different from the first processing conditions. This forms the plurality of strings 120 on the base substrate 110, each with a string width wT2 (=wT1) and an inter-string distance of wL2 (<wL1). Next, as shown in Fig. 9F, a second laser processing step (element separation step) is performed to form a submodule. This becomes the "second submodule 102."

In this way, the second processing conditions for forming the second submodule are set to the same non-irradiated width as the first processing conditions, while setting only the irradiated width to be smaller, thereby forming the second submodule 102. The laser output for the laser processing is the same under both the first and second processing conditions.

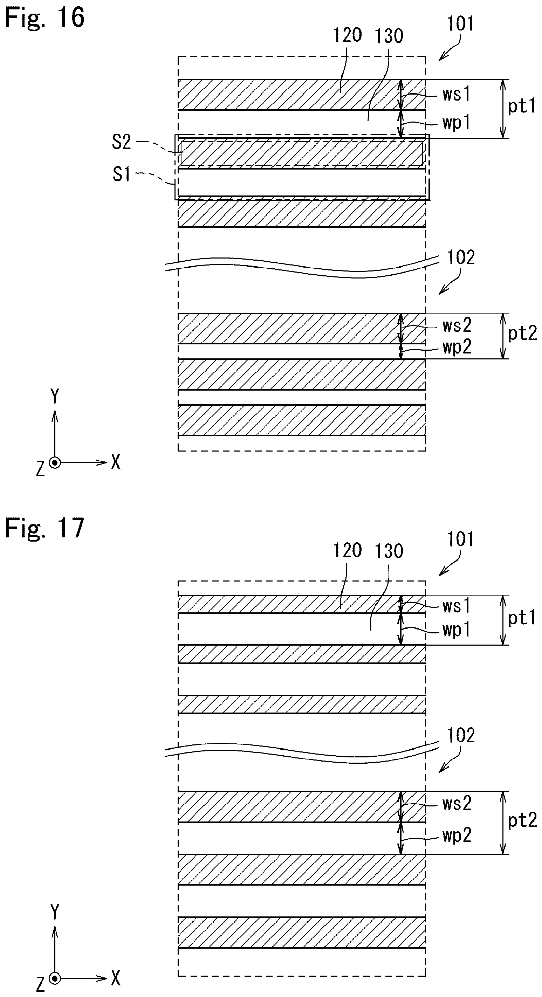

The first and second submodules formed under these conditions have the relationship shown in Table 1 (see Fig. 16). These submodules have the same string width, but different inter-string region widths.

In this way, by forming the laminated film 170 on the base substrate 110 under common formation conditions in advance and fabricating plural base submodules (base submodules with laminated film), the first submodule 101 and the second submodule 102 can be manufactured from the base submodule by changing the processing conditions of the first laser processing step.

·Wiring Formation Step

Fig. 11 is a schematic top view illustrating the wiring formation step. As shown in Fig. 11, the wirings (e.g., tab wires) 141, 142 are formed on the base substrate 110 on which the strings 120 have been formed by the above method. In this manner, the submodule 100 is manufactured.

The wirings 141, 142 are respectively disposed on one end and the other end of the substrate 110 in the X-direction. In plan view seen along the Z-direction, the wirings 141, 142 are longer than the length of the substrate 110 in the Y-direction, and the upper and lower ends of the wirings 141, 142 may extend outside the substrate 110. The wiring 141 is connected to the upper or lower transparent conductive layer at the left end of each string 120 at one end of the base substrate 110. Similarly, the wiring 142 is connected to the upper or lower transparent conductive layer at the right end of each string 120 at the other end of the base substrate 110. Each of the wirings 141, 142 may be connected to the upper surface of the end of the lower transparent conductive layer by, for example, soldering.

(Method for Manufacturing Power Generation Module)

Next, a method for manufacturing the power generation module 1 using the submodule 100 (Fig. 11) manufactured by the above method will be described with reference to Figs. 12A to 13C.

The method for manufacturing the power generation module includes, for example, a submodule arrangement step in which plural submodules are arranged on a first substrate and electrically connected to each other, and a sealing step in which the first substrate and a second substrate are bonded together with the plural submodules in between.

·Submodule Arrangement Step

Figs. 12A and 12B are schematic process top views explaining the submodule arrangement step.

First, a first substrate (e.g., a glass substrate) is prepared, and a plurality of submodules 100 are arranged on the first surface 11s of the first substrate via a filler (filler 31 shown in Fig. 2, etc.). For example, a filler sheet containing polyolefin is used as the filler. Here, 12 submodules 100 may be arranged in four rows and three columns.

In this embodiment, as shown in Fig. 12A, the wirings 141 and the wirings 142 of two submodules 100 adjacent in the Y-direction (column direction) are connected using, for example, solder. The wirings 141 of the submodules 100 in the same column are connected in the Y-direction to form the first wiring 41a extending in the Y-direction. Similarly, the wirings 142 of the submodules 100 in the same column are connected in the Y-direction to form the second wiring 42a extending in the Y-direction. This results in the module column Ra in which the submodules 100 in the same column are connected in parallel. Similarly, in the other module columns Rb, Rc, the first wirings 41b, 41c and second wirings 42b, 42c are formed to connect four submodules 100 in parallel.

As shown in Fig. 12B, the second wiring 42a of the module column Ra and the first wiring 41b of the module column Rb are electrically connected by the third wiring 43. The third wiring (e.g., a tab wire) 43 may be connected to the second wiring 42a and the first wiring 41b by, for example, soldering. Similarly, the second wiring 42b of the module column Rb and the first wiring 41c of the module column Rc are connected by the third wiring 43. This connects the module columns Ra to Rc in series.

Substantially, the lead wire 21 is connected to the first wiring 41a of the leftmost module column Ra, and the lead wire 22 is connected to the second wiring 42c of the rightmost module column Rc. In this way, a first substrate with submodules is formed.

In this example, at least one third wiring 43 is arranged between two submodules 100 adjacent in the X-direction, but the number and arrangement (position in the Y-direction) of the third wiring 43 are not limited to the example shown in the figure.

·Sealing Step

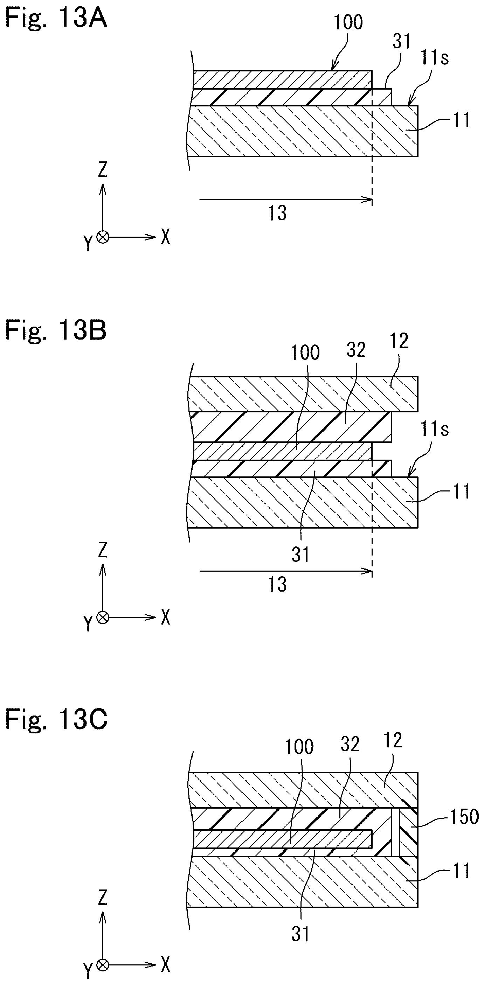

Figs. 13A to 13C are schematic process cross-sectional views for explaining the sealing step. Fig. 13A shows the state in which the submodules 100 are arranged on the first surface 11s of the first substrate 11 via the filler 31 by the method described above.

As shown in Fig. 13B, the second substrate 12 is placed above the submodule 100 shown in Fig. 13A via the filler 32. For example, a filler sheet containing polyolefin is used as the filler 32. In plan view from the Z-direction, the fillers 31 and 32 may have a size larger than the central region 13 in which the submodule 100 is placed. In plan view seen along the Z-direction, the periphery of the filler sheet may be located between the outer edge of the central region 13 and the peripheries of the first substrate 11 and the second substrate 12.

After this, lamination is performed. In the lamination process, as shown in Fig. 13C, the fillers 31 and 32 melt under reduced pressure and flow around to cover the side surfaces of the submodule 100 (the side surfaces close to the edges of the first substrate 11), bonding the first substrate 11 and the second substrate 12 together. This reduces the likelihood of an air layer remaining near the side surfaces of the submodule 100, thereby suppressing the influence of air on the photovoltaic layer. As shown in the figure, the entire side surfaces of the submodule 100 may be covered with the fillers 31 and 32. Next, a sealing member (e.g., butyl rubber) 50 is disposed between the first substrate 11 and the second substrate 12, outside the central region 13, thereby sealing the space between the first substrate 11 and the second substrate 12. The sealing member 50 is disposed, for example, so as to surround the central region 13. The sealing member 50 may also be disposed outside the fillers 31 and 32. In this manner, the power generation module 1 is manufactured.

In the above, the sealing member 50 is disposed and sealed after lamination, but the lamination may be performed after the sealing member 50 is disposed and sealed.

(Setting Light Transmittance of Submodule)

As described above, in this embodiment, the light transmittance of the submodule can be adjusted by adjusting the total area of the photovoltaic film removed when manufacturing each submodule.

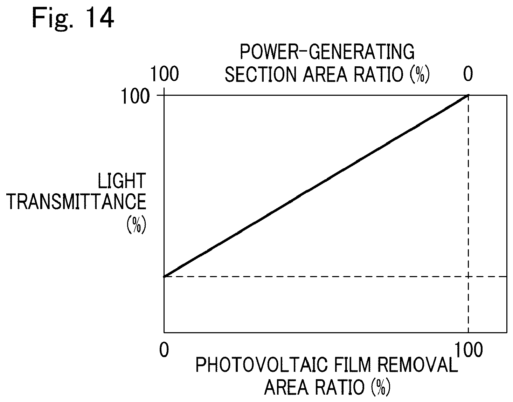

Fig. 14 is a schematic diagram showing the relationship between the photovoltaic film removal area ratio and power-generating section area ratio of the submodule and the light transmittance in the thickness direction (Z-direction) of the submodule.

The "light transmittance" on the vertical axis of the graph shown in Fig. 14 is the light transmittance excluding the wiring (tab wires) formed on both ends of the submodule. The "photovoltaic film removal area ratio" is the ratio of the area of the photovoltaic film removed by laser processing or the like to the main surface of the base substrate. A photovoltaic film removal area ratio of 0% refers to a state in which the photovoltaic film is formed over the entire main surface of the base substrate. The power-generating section area ratio at this time is, for example, 100%. A photovoltaic film removal area ratio of 100% refers to a state in which the photovoltaic film has been removed from the entire main surface of the base substrate and no photovoltaic film remains, and the power-generating section area ratio is 0%.

As can be seen from Fig. 14, the light transmittance increases as the area of the photovoltaic film removed increases. In other words, the light transmittance increases as the power-generating section area ratio decreases. The light transmittance of the submodule when all of the photovoltaic film is removed is approx. 100%, ignoring the light transmittance of the first and second substrates. The relationship between light transmittance and the area ratio of the photovoltaic film removed shown in Fig. 14 is an example, and may vary depending on the material, thickness, and formation method of the photovoltaic film, the structure of the power-generating section, etc.

By utilizing the relationship shown in Fig. 14, it is possible to set the light transmittance for each submodule.

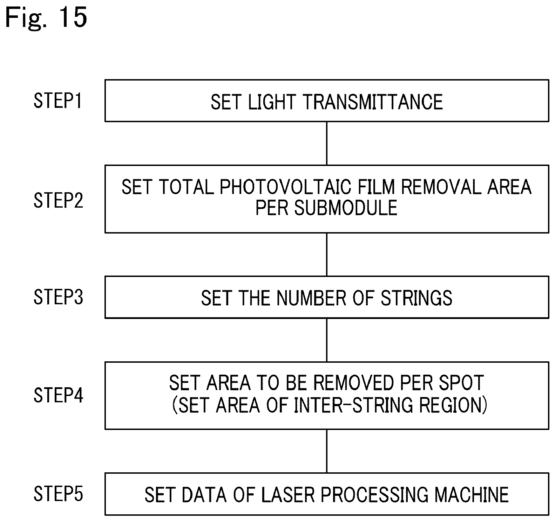

Fig. 15 is a flowchart showing an example of a method for setting the light transmittance of a submodule. Here, an example will be described in which a submodule is designed with the width of each string set to a constant value.

First, the light transmittance (target value) of the submodule is set according to requirements such as the use, design quality, and power generation amount (power generation efficiency per unit area) of the power generation module (STEP 1).

Next, the total area of the photovoltaic film to be removed is set based on the target value of light transmittance (STEP 2). For a photovoltaic film made of the same material as the photovoltaic film used in the submodule, the relationship between the photovoltaic film removal area ratio and light transmittance may be determined in advance, as shown in Fig. 14. The removal area can be set based on this relationship.

Next, the number of the strings is set based on the removal area (STEP 3). Furthermore, the area of the photovoltaic film to be removed by one laser irradiation (i.e., the area of the inter-string region) is set (STEP 4). Based on this setting, data for the laser processing machine (laser irradiation position, irradiation width, etc.) is set (STEP 5).

In the above method, the string width is designed to be constant, but the width of the inter-string region may also be designed to be constant. Alternatively, the string array pitch may be designed to be constant. The string width is the width determined based on, for example, the non-irradiated width wT shown in Figs. 10A to 10C. The inter-string region width is the width determined based on the irradiated width wL shown in Figs. 10A to 10C.

(Example of String Structure of First and Second Submodules)

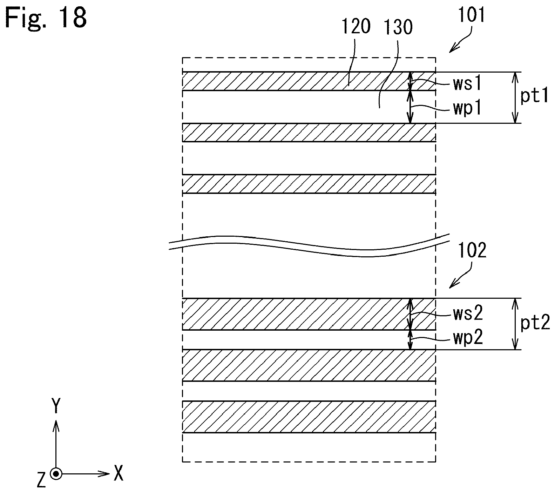

An example of the string structure will be described with reference to Figs. 16 to 18. Figs. 16 to 18 are schematic enlarged top views of two adjacent submodules 101 and 102. Wiring is not shown in these figures.
The string structures shown in Figs. 16 to 18 are referred to as the first string structure to the third string structure, respectively. The overview of each structure is shown in Table 1. Table 1 shows the relationship between the string width ws1, the width (inter-string region width) wp1 of the inter-string region, the number (total number) N1 of the strings, and an array pitch pt1 of the first submodule 101, and the string width ws2, the width of the inter-string region wp2, the number N2 of the strings, and an array pitch pt2 of the second submodule 102 for each structure. The "array pitch" here refers to the distance between the top ends of two strings 120 adjacent in the Y-direction, and is a distance equivalent to the sum of the string width and the inter-string region width.

[Table 1]

|  | 1st String Structure | 2nd String Structure | 3rd String Structure |
| --- | --- | --- | --- |
| String Width | ws1=ws2 | ws1<ws2 | ws 1 <ws2 |
| Inter-String Region Width | wp1>wp2 | wp1=wp2 | wp1>wp2 |
| Number of Strings | N1<N2 | N1>N2 | N1=N2 |
| Array Pitch | pt1>pt2 | pt1<pt2 | pt1=pt2 |

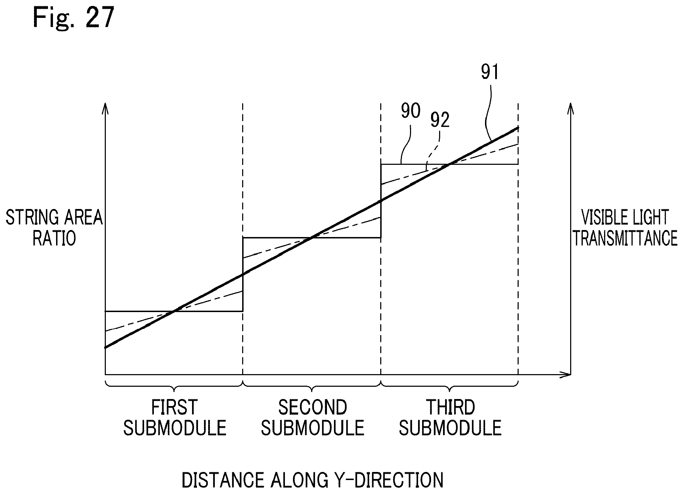

According to the first string structure, by making the string widths ws1, ws2 of the submodules 101, 102 identical, it is possible to obtain the same power generation output from each string 120 in the submodules 101, 102.
The second string structure has the advantage that by making the inter-string region widths wp1 and wp2 of the submodules 101 and 102 identical, the two submodules 101 and 102 can be manufactured under the same processing conditions (laser irradiation width) in the process of processing the photovoltaic film.
In the third string structure, the array pitch pt of the strings 120 is constant in the two submodules 101 and 102, but the string width and the width of the inter-string region are different from each other, which makes it easier to design each submodule.
In the first to third string structures, the string area ratio is constant for each pitch in each of the submodules 101, 102. As illustrated in Fig. 16, the "string area ratio" refers to the ratio of the area S2 of the string 120 to the total area S1 of the string 120 and the inter-string region 130 adjacent to that string 120 in the second direction (for example, the -Y-direction). Therefore, when the array pitches pt1, pt2 are sufficiently small relative to the length of the main surface in the Y-direction, the light transmittance is substantially uniform within each of the submodules 101, 102.
The first to third string structures can be applied to the module column Ra (Fig. 7) including three or more submodules 101 to 103 arranged in the Y-direction. This makes it possible to vary the light transmittance in the Y-direction in the module column Ra, as shown by line 90 in Fig. 27. In other words, in this embodiment, a gradation is formed not in each submodule but in the entire module column Ra.
The configuration of the power generation module in this embodiment is not limited to the illustrated example. For example, in the top view shown in Fig. 2, the Y-direction may be the width direction of the window, and the X-direction may be the height direction of the window. The power-generating section of the power generation module 1 need only have at least one solar cell element and need not have a solar cell element string structure. Each submodule 100 only needs to be electrically connected to at least one other submodule, and the wiring structure may be selected as appropriate. In the illustrated example, the thickness, shape (size), and material of the plural submodules 100 constituting the power generation module 1 are all the same, but may be different. Furthermore, the sealing structure between the submodule 100 and the first substrate 11 and the second substrate 12, the structure of the filler, and the like may be changed as appropriate.
The shape, material, etc. of each component of the power generation module are not particularly limited. For example, the first substrate 11, the second substrate 12, or the base substrate 110 of the submodule 100 are not limited to glass substrates and may be transparent resin substrates such as acrylic. Furthermore, in the above embodiment, the photovoltaic layer PV containing a perovskite compound is used, but the photovoltaic layer PV may also be a layer containing other known photoelectric conversion materials, such as a thin-film silicon-based semiconductor layer of amorphous silicon or microcrystalline silicon, a compound semiconductor layer of CIS or CIGS, or an organic semiconductor layer.

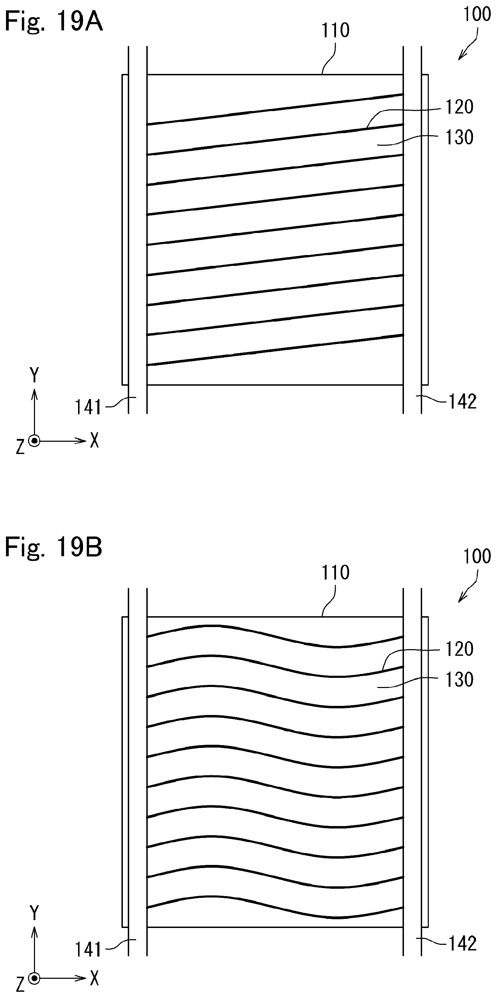

The configuration of the submodule 100 is not limited to the example shown in the figure. The plural strings 120 only need to extend from one end to the other end of the base substrate, and do not have to extend along the X-direction. For example, as illustrated in Fig. 19A, some or all of the strings 120 may extend obliquely with respect to the Y-direction. Alternatively, as illustrated in Fig. 19B, some or all of the strings 120 may extend in a curved line.

(Effect)

As described above, the power generation module 1 includes the plural submodules 100. The plural submodules 100 includes a first submodule 101 and a second submodule 102 that are arranged adjacent to each other in plan view seen along the first direction. Each of the plural submodules 100 includes the base substrate 110 having light-transmitting properties and a power-generating section located on a portion of a main surface 110s of the base substrate 110. The power-generating section includes at least a photovoltaic layer PV supported on the main surface 110s. In plan view, the area ratio of the power-generating section (power-generating section area ratio) to the main surface 110s in the first submodule 101 is smaller than the area ratio of the power-generating section to the main surface 110s in the second submodule 102.

The power generation module 1 includes two submodules 101 and 102 with different power-generating section area ratios, so that the function, design, etc. can be changed depending on the position, thereby increasing the degree of freedom in design.

More specifically, the larger the power-generating section area ratio of each submodule 100, the higher the power generation efficiency per unit area, but the lower the light transmittance. Therefore, by differentiating the power-generating section area ratios of the two submodules 101 and 102, it is possible to differentiate not only the power generation efficiency per unit area but also the light transmittance. This allows for design based on the intended use of the power generation module 1 (such as the building materials used and the environment in which it is used). Furthermore, the difference in light transmittance can be utilized to enhance the design quality.

Generally, a solar cell array is formed by arranging solar cells with the same structure (same power generation performance). In contrast, in this embodiment, a power generation module is formed by combining plural submodules with different power-generating section structures (power generation performance), thereby adding, for example, design features.

In this embodiment, the power-generating section itself, which has solar cell functionality, is used to achieve the desired design quality or light transmittance, eliminating the need for additional components. This makes it possible to provide a power generation module with a high level of design while minimizing the number of manufacturing steps and components.

The power generation module 1 further includes the first substrate 11 having light-transmitting properties and the second substrate 12 having light-transmitting properties. The second substrate 12 is disposed to face the first substrate 11 in the first direction (Z-direction). The plural submodules 100 are located between the first substrate 11 and the second substrate 12. The main surface 110s of the base substrate 110 of each submodule 100 is disposed to face the second substrate 12, for example.

According to the above configuration, the power generation module 1 has a configuration in which the plural submodules 100 are smaller than the first substrate 11 and the second substrate 12 and are arranged between the first substrate 11 and the second substrate 12, so that it can support various sizes of building materials through the number and arrangement of the submodules 100.

Furthermore, in the power generation module 1, the first substrate 11, the second substrate 12, and the base substrate 110 have light-transmitting properties, allowing light to pass through in the first direction of the power generation module 1. Accordingly, the power generation module 1 can be suitably applied to applications requiring high visible light transmittance, such as building material-integrated solar cells for building windows.

In each of the first submodule 101 and the second submodule 102, the power-generating section may include the plurality of strings 120 supported on the main surface 110s of the base substrate 110. Each of the plurality of strings 120 is a solar cell element string 120 having a structure in which the plurality of solar cell elements 150 are connected in series. In plan view seen along the first direction, each of the plurality of strings 120 extends from one end side to the other end side of the base substrate 110. With the above configuration, in each of the submodules 101, 102, it is possible to design the transmittance and implement a desired design by changing the number, arrangement, etc. of the strings 120.

The first submodule and the second submodule may be adjacent to each other in the second direction in plan view, and each of the first submodule 101 and the second submodule 102 may further include the first wiring 141 arranged on one end side of the base substrate 110 and the second wiring 142 arranged on the other end side of the base substrate 110. In each of the first submodule 101 and the second submodule 102, the plural strings 120 may be arranged at a distance from each other in the second direction. Each of the plural strings 120 may extend from the first wiring 141 to the second wiring 142 in the third direction (X-direction) intersecting the second direction.

According to the above configuration, the plural strings 120 are connected in parallel in each of the submodules 101, 102. This reduces the influence on the power generation performance of the submodules of differences in power generation performance due to differences in string width, even when the strings 120 with different widths are formed (see the embodiment described later).

In at least one of the first submodule 101 and the second submodule 102, the plural strings 120 may be arranged at equal intervals in the second direction in plan view along the first direction. With the above configuration, in the photovoltaic film processing step for manufacturing the submodule, laser processing for forming the plural strings 120 can be performed with the processing conditions (irradiation width wL of the laser beam LB) set to a constant value.

The plural submodules 100 may further include the third submodule 103 located on the side of the second submodule 102 opposite to the first submodule 101 in the second direction. In plan view seen along the first direction, the area ratio of the power-generating section to the main surface 110s of the second submodule 102 may be smaller than the area ratio of the power-generating section to the main surface 110s of the third submodule 103. With this configuration, it is possible to change the light transmittance in the second direction in a module column including the submodules 101 to 103 (see line 90 in Fig. 27).

The plural submodules 100 may further include the fourth submodule 104. In plan view seen along the first direction, the fourth submodule 104 is disposed adjacent to the first submodule 101 in the third direction intersecting the second direction. In plan view seen along the first direction, the area ratio of the power-generating section to the main surface 110s of the fourth submodule 104 may be equal to the area ratio of the power-generating section to the main surface 110s of the first submodule 101.

The fourth submodule 104 need not be designed specifically for it, and may be the same as the first submodule 101. In this case, there is no need to design an area ratio specifically for the fourth submodule, and it is sufficient to arrange the same one as the first submodule 101. Furthermore, the strings 120 of the first submodule 101 and the fourth submodule 104 are arranged on the first substrate 11 so as to be substantially aligned in the X-direction. This makes it possible to make the transmittance constant in the X-direction. Furthermore, a sense of unity can be achieved in the design of the power generation module.

The above configuration makes it possible to maintain the light transmittance of the power generation module 1 constant in the third direction (X-direction). This allows for a unified design, particularly when the power generation module 1 is applied to a large-area building material. Furthermore, the current capacity of the first submodule 101 and the fourth submodule 104 can be made the same, which is particularly advantageous when these submodules are connected in series.

The first submodule 101 and the second submodule 102 may be connected in parallel. This allows for increased output current. Furthermore, compared to connecting the submodules 101 and 102 in series, the influence on the power generation performance of the power generation module 1 of differences in power generation performance due to differences in the power-generating section area ratio between the submodules 101 and 102 can be reduced.

The plural submodules 100 may form a solar cell array. For example, the power generation module 1 includes plural module columns Ra to Rc. Each module column includes at least the first submodule 101 and the second submodule 102, and extends in the second direction in plan view along the first direction. The plural module columns Ra to Rc are arranged in the third direction (X-direction) that intersects with the second direction, and are connected in series. With this configuration, the maximum current and maximum voltage of the power generation module 1 can be set within a desired range by combining series and parallel connections.

The photovoltaic layer PV may contain, for example, a perovskite compound. A photovoltaic film (perovskite film) containing a perovskite compound can be easily formed using coating techniques such as inkjet printing and spin coating. Furthermore, the perovskite film coated on the substrate can be easily processed into a fine shape, for example, by laser processing, further enhancing design flexibility. As a result, it is easy to form a precise gradation using the plural strings 120. Thus, using a layer containing a perovskite compound as the photovoltaic layer PV can further increase design freedom. Therefore, it can be more suitably applied to building-integrated solar cells.

According to this embodiment, the process of forming the submodule 100 includes the film formation step of forming the laminated film 170 including a photovoltaic film on the main surface 110s of the base substrate 110 having light-transmitting properties, and the film processing step of processing the laminated film 170 to form a power-generating section (e.g., plural strings 120) including a photovoltaic layer PV on a portion of the main surface 110s. The film processing step includes a laser processing process of removing a portion of the photovoltaic film from the main surface 110s by laser processing, so that the remaining portion of the photovoltaic film becomes the photovoltaic layer PV of the power-generating section. In the laser processing process, the area of the photovoltaic film removed relative to the area of the main surface 110s is made different between the first submodule 101 and the second submodule 102.

The above method allows for the manufacture of the power generation module 1 including two submodules 101, 102 with different removal area ratios of the photovoltaic film, i.e., different area ratios of the photovoltaic layer PV constituting the power-generating section. The light transmittance of the submodules 101 and 102 can vary depending on the removal area ratio of the photovoltaic film. Hence, the above method makes it possible to easily separately fabricate two submodules with different light transmittances by simply varying the laser processing conditions (e.g., the irradiation width wL and non-irradiation width wT of the laser beam LB). Furthermore, various designs can be implemented by varying the combination and arrangement of submodules with different light transmittances. For example, a power generation module can be manufactured by selecting and combining submodules according to customer requirements. Thus, a power generation module with excellent design quality can be manufactured while suppressing the increase in the number of manufacturing steps and manufacturing costs.

«Second Embodiment»

A power generation module according to a second embodiment of the present disclosure will be described below. The power generation module of this embodiment differs from the first embodiment in that, in at least one submodule, plural strings are arranged to form a gradation. The following description will mainly focus on the differences from the first embodiment, and will omit duplicate description as appropriate.

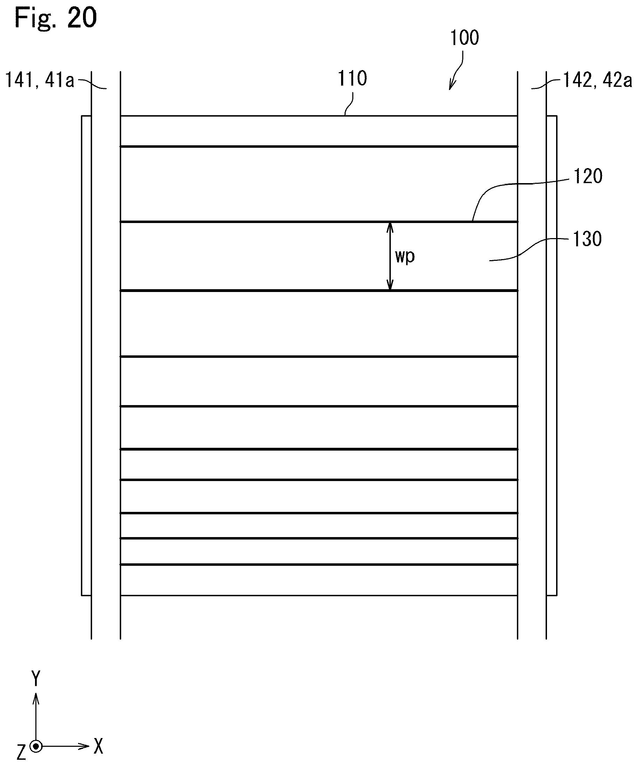

Fig. 20 is an enlarged top view showing one submodule in the second embodiment of the present disclosure.

As shown in Fig. 20, in the submodule 100, the plural strings 120 are arranged to form a gradation in which the inter-string region width wp gradually changes along the Y-direction. The widths (string widths) of the strings 120 may be the same or different. As will be described later, a gradation can also be formed by gradually changing the string width, string area ratio, etc. within one submodule.

According to this embodiment, by forming a gradation in the strings 120, it is possible to set the power-generating section area ratio of the submodule, and hence the light transmittance.

(Example of String Structure of First and Second Submodules)

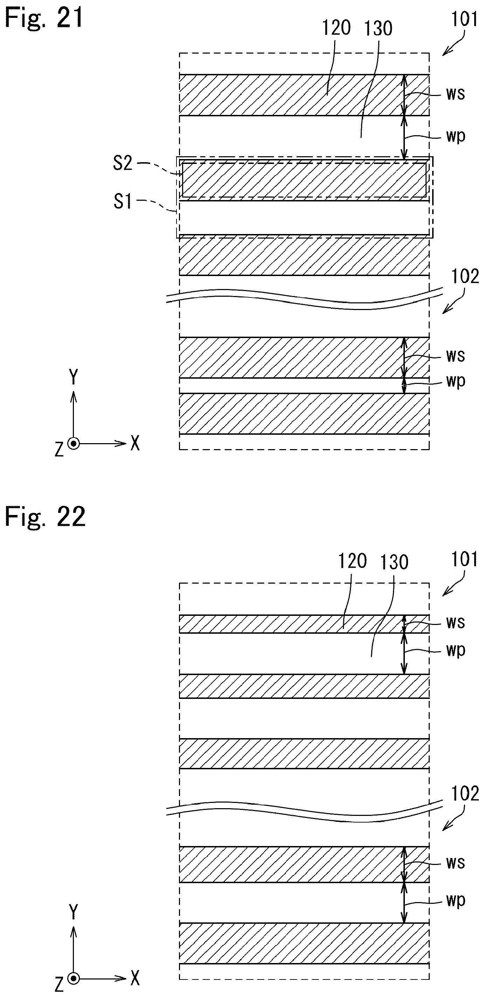

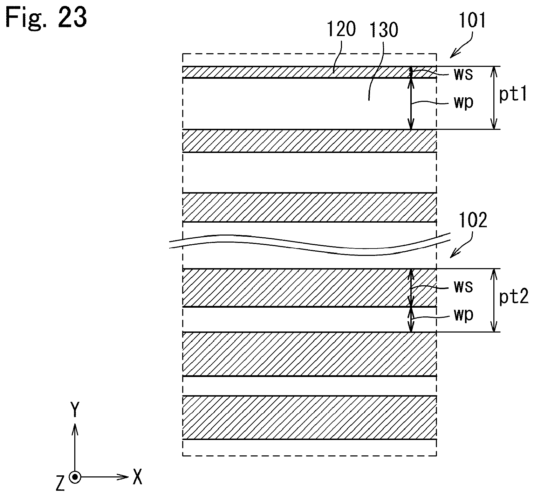

A gradation may be formed across two adjacent submodules. Design examples of the string structures will be described with reference to Figs. 21 to 23.

Figs. 21 to 23 are each a schematic enlarged top view of two adjacent submodules 101 and 102. In these figures, wiring is not shown.

In the example shown in Figs. 21 to 23, the power-generating section area ratio of the submodule 101 is smaller than the power-generating section area ratio of the submodule 102. In addition, a gradation is formed in which the string area ratio (S2/S1 shown in Fig. 21) gradually increases along the direction (-Y-direction) from the submodule 101 to the submodule 102.

The string structures shown in Figs. 21 to 23 are referred to as the fourth to sixth string structures, respectively. An overview of each structure is shown in Table 2. In Table 2, "gradual decrease (or increase)" means gradually decreasing (or increasing) in the -Y-direction.

[Table 2]

|  | 4th String Structure | 5th String Structure | 6th String Structure |
|---|---|---|---|
| String Width ws | constant | gradual increase | gradual increase |
| Inter-String Region Width wp | gradual decrease | constant | gradual decrease |
| Number N of Strings | N1<N2 | N1>N2 | N1=N2 |
| Array Pitch pt | gradual decrease | gradual increase | pt1=pt2 |

In the fourth string structure, the inter-string region width wp is set to gradually decrease in the second direction (here, the -Y-direction) from submodule 101 to submodule 102. Because the string width (width of the power-generating section) ws is constant, it is possible to make the power generation output of the plural strings 120 identical.

In the fifth string structure, the string width ws is set to gradually increase along the second direction (here, the -Y-direction) from the submodule 101 to the submodule 102. Because the inter-string region width wp is constant, this has the advantage that it is not necessary to change the processing conditions (laser irradiation width) for each string when processing the photovoltaic film. Furthermore, each submodule 101, 102 has a structure in which the plural strings 120 with different string widths (solar cell element widths) ws are connected in parallel. In this way, by intentionally combining plural strings (plural solar cell elements) with different power-generating section structures (power generation performance) to form a submodule, design features are added to the submodule.

In the sixth string structure, the string array pitch pt is constant from the submodule 101 to the submodule 102. By changing both the string width ws and the inter-string region width wp, the string area ratio is set to gradually increase along the second direction.

According to the fourth to sixth string structures, the strings 120 of the submodule 101 are arranged so that the string area ratio increases as they approach the submodule 102. On the other hand, the strings 120 of the submodule 102 are arranged so that the string area ratio increases as they move away from the submodule 101. The minimum string area ratio of the submodule 102 is greater than the maximum string area ratio of the submodule 101. This allows a gradation to be formed across the submodules 101 and 102.

(Method for Setting Light Transmittance of Submodule)

In this embodiment, the light transmittance of each submodule can also be set in a manner similar to that described with reference to Figs. 14 and 15. Note that, in order to form a gradation, the string width ws and/or the inter-string region width wp are set according to the position (the position in the second direction) on the main surface of the base substrate.

In the examples shown in Figs. 21 to 23, the string width, etc. is changed for each string, but the main surface 110s of the base substrate 110 may be divided into plural regions in the second direction, and the string width, inter-string region width, etc. may be made different for each region.

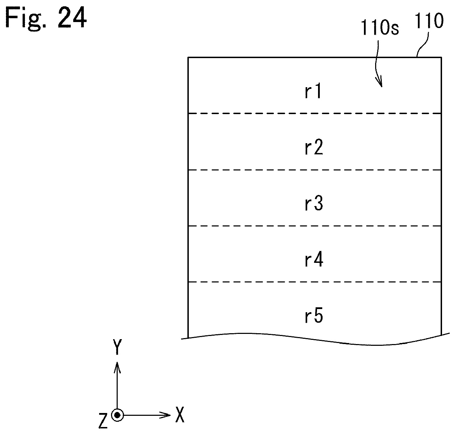

Table 3 shows a design example of a sixth string structure. In this example, as shown in Fig. 24, the main surface 110s of the base substrate 110 is divided into plural regions r1 to r5 in the second direction, and the string width ws and inter-string region width wp are set for each region. In Table 3, the widths ws and wp are shown as ratios to the array pitch pt.

[Table 3]

| | String Width ws | Inter-String Region Width wp | Array Pitch pt |
|---|---|---|---|
| Region r1 | 0.9 | 0.1 | 1 |
| Region r2 | 0.8 | 0.2 | 1 |
| Region r3 | 0.7 | 0.3 | 1 |
| Region r4 | 0.6 | 0.4 | 1 |
| Region r5 | 0.5 | 0.5 | 1 |

(Module Column Gradation)

When the fourth to sixth string structures (Figs. 21 to 23) are applied to a module column having, for example, three or more submodules, a gradation in which the string area ratio changes in one direction can be formed in the module column (not only within each submodule but also between submodules). Therefore, each submodule has its own gradation, and plural (e.g., three) submodules as a whole can have a gradation that incorporates the individual gradations.

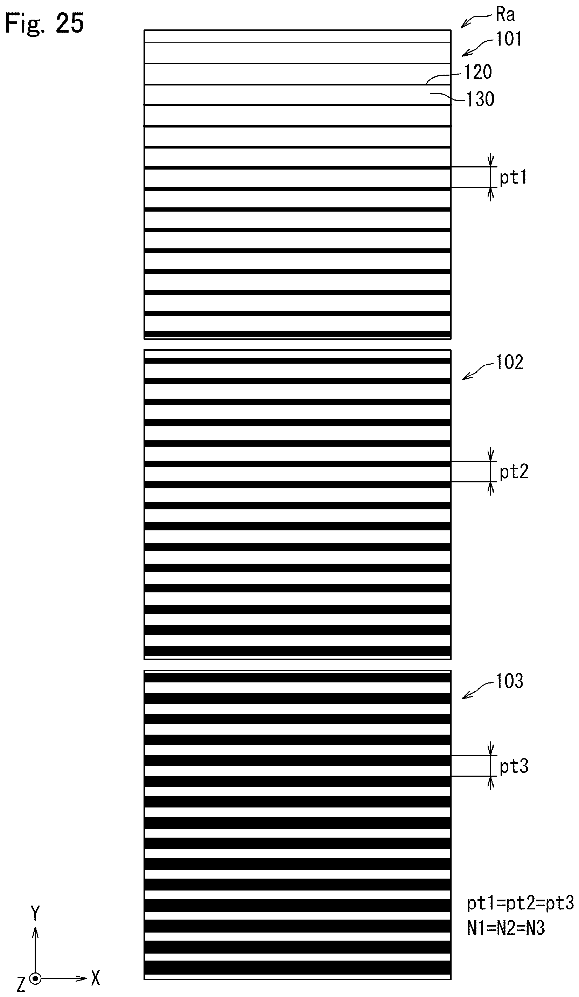

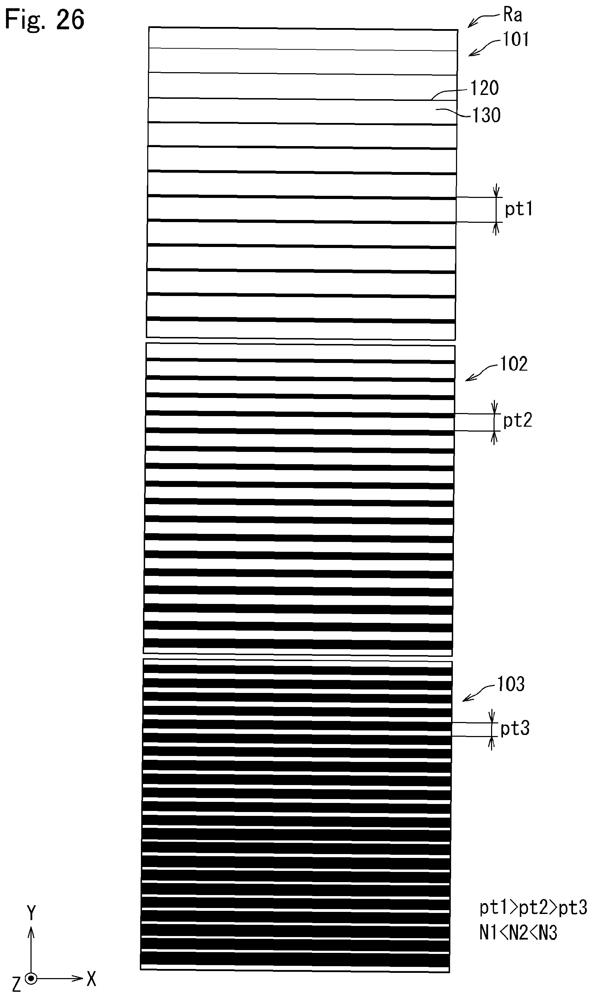

Figs. 25 and 26 are schematic top views illustrating an example of a module column gradation. These figures illustrate the module column Ra including the submodules 101 to 103. In the module column Ra, a gradation is formed from the top end of the submodule 101 to the bottom end of the submodule 103.

In the example shown in Fig. 25, the array pitches pt1, pt2, pt3 and the numbers N1, N2, N3 of the strings in the submodules 101 to 103 satisfy the following relationships:

$$pt1=pt2=pt3$$

$$N1=N2=N3$$

(here 15) In the module column Ra, the string width ws gradually increases (here, in 45 steps) along the second direction (here, the -Y-direction). The inter-string region width wp gradually decreases along the second direction. This forms a gradation in which the string area ratio gradually increases along the second direction.

In the example shown in Fig. 25, the string area ratio varies regularly (or quasi-regularly) in the second direction across the module column Ra. Therefore, as shown schematically by line 91 in Fig. 27, the light transmittance can be smoothly increased across the plural submodules 101 to 103 in the module column Ra. For example, the amount of change in the string area ratio across two adjacent submodules is substantially the same as the amount of change in the string area ratio within each submodule. The string area across the two submodules may also vary with the same regularity as within each submodule. Note that in Fig. 27, the string width and spacing are assumed to be sufficiently small compared to the size of the base substrate, and the gradual change in the string area ratio at each pitch is represented approximately as a straight line.

In the module column Ra shown in Fig. 26, the array pitches pt1 to pt3 and the numbers N1 to N3 of the strings in the submodules 101 to 103 satisfy the following relationship.

$$pt1 > pt2 > pt3$$

$$N1 < N2 < N3$$

In each of the submodules 101 to 103, the strings 120 are arranged at equal pitches. The string width ws gradually increases along the second direction (here, the -Y-direction), and the inter-string region width wp gradually decreases along the second direction. This module column Ra can be said to be a configuration in which the string width is varied, for example, applied to the submodules 101 to 103 shown in Fig. 7.

In the example shown in Fig. 26, each of the submodules 101 to 103 has a gradation, and the string area ratio changes rapidly between adjacent submodules. For example, the change in string area ratio across two adjacent submodules is greater than the change in string area ratio within each submodule. Therefore, as shown schematically by a line 92 in Fig. 27, the change in light transmittance in the module column is greater between two adjacent submodules than within these two submodules.

Figs. 25 and 26 show only three submodules 101 to 103, but a module column having a gradation may be formed by four or more submodules. Furthermore, plural module columns having the same gradation structure may be arranged in the X-direction. Furthermore, the gradation of this embodiment may be formed in one region across plural submodules. For example, the gradation may be formed only in the lower portion of the first submodule and the upper portion of the second submodule in plan view.

(Method for Manufacturing Submodule)

The submodule with gradation can be manufactured by the same method as in the above embodiment, except for the film processing step of processing the photovoltaic film. Hereinafter, as for the film processing step in this embodiment, differences from the step described above with reference to Figs. 10A to 10C will be described, and similar description will be omitted as appropriate.

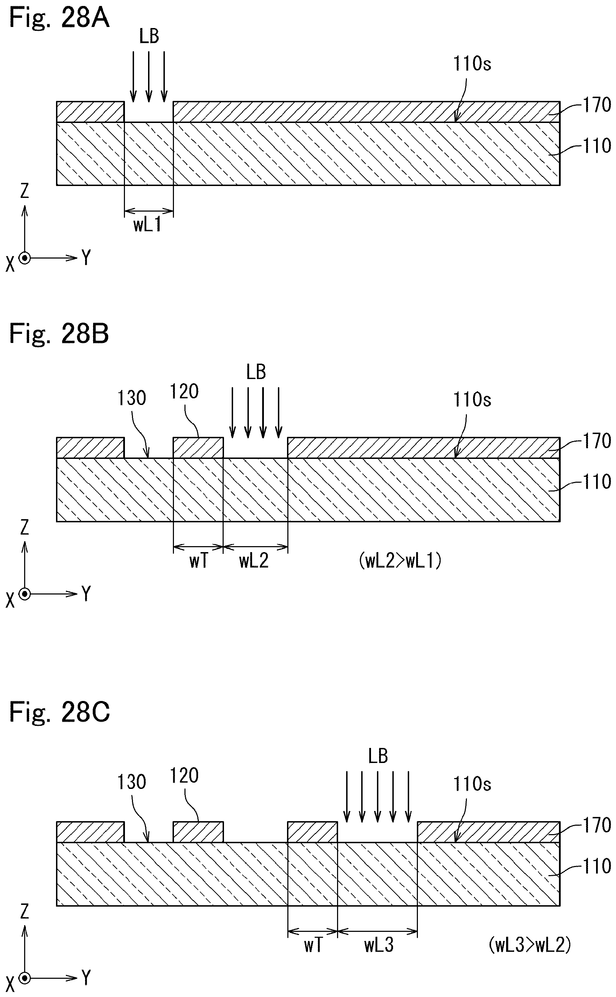

Figs. 28A to 28C are schematic process cross-sectional views illustrating a method for processing a laminated film including a photovoltaic film.

The method shown in Figs. 28A to 28C are applied to a configuration in which the width of the inter-string region is gradually changed (see Fig. 21). This method differs from the method shown in Figs. 10A to 10C in that the irradiation width (irradiation range) is set so that the width of the removed laminated film gradually increases (or decreases).

As shown in Fig. 28A, the laser beam LB is scanned in the X-direction, and the laminated film 170 is irradiated with the laser beam LB at an irradiation width wL1. This removes the irradiated portion of the laminated film 170. Next, as shown in Fig. 28B, the irradiation position of the laser beam LB is shifted in the Y-direction by a predetermined distance (non-irradiation width) wT, and the laminated film 170 is irradiated with the laser beam LB at an irradiation width wL2 (wL2 > wL1) that is larger than the irradiation width wL1. As shown in Fig. 28C, the laminated film 170 is processed by shifting the irradiation position at equal intervals in the Y-direction and changing the irradiation width. In this way, a gradation in which the spacing between the strings 120 gradually changes in the Y-direction is formed on the main surface 110s.

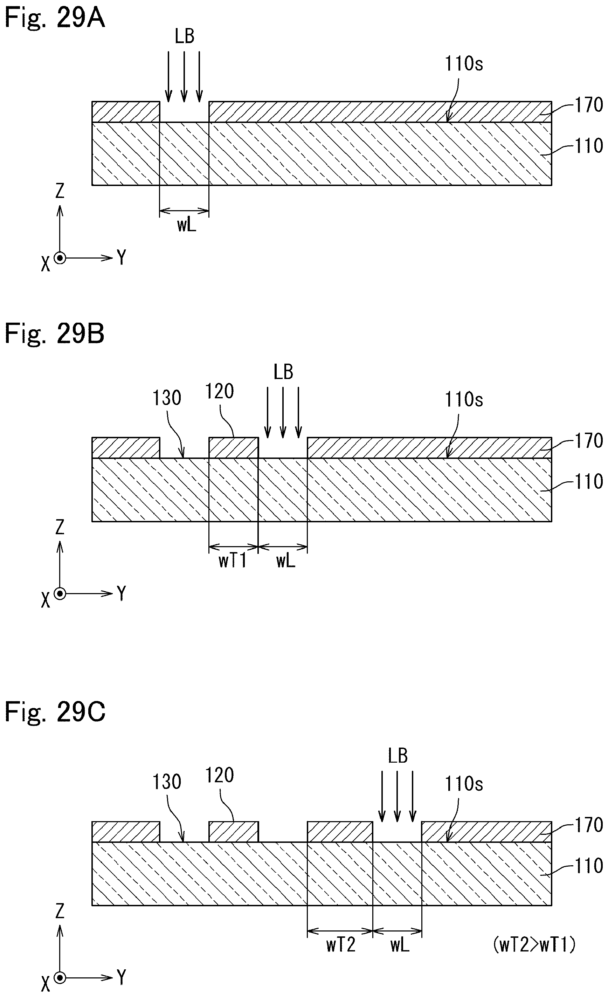

Figs. 29A to 29C are each a schematic process cross-sectional view illustrating another method for processing a laminated film including a photovoltaic film.

The method shown in Figs. 29A to 29C is applied to a configuration in which the string width is gradually changed (see Fig. 22). This method differs from the method shown in Figs. 10A to 10C in that the laminated film is processed while varying the moving distance (non-irradiation width) of the laser head.

Specifically, as shown in Fig. 29A, first, laser beam LB is scanned in the X-direction to irradiate the laminated film 170 with the laser beam LB over an irradiation width wL, thereby removing the irradiated portion of the laminated film 170. Next, as shown in Fig. 29B, the irradiation position of the laser beam LB is shifted in the Y-direction by a predetermined distance (non-irradiation width) wT1, and the laminated film 170 is irradiated with the laser. Subsequently, as shown in Fig. 29C, the irradiation position of the laser beam LB is shifted in the Y-direction by a non-irradiation width wT2 that is larger than the non-irradiation width wT1, and laser irradiation is performed. This forms a gradation in which the width of the string 120 gradually changes.

<Effects, etc.>

In this embodiment, in each of the plural submodules 100, the main surface 110s of the base substrate 110 includes plural inter-string regions 130 located between two adjacent strings 120. At least the string 120 of the first submodule 101 may be configured, for example, as follows.

The plural strings 120 are arranged at distances from one another in the second direction so that at least one of the string width ws, the inter-string region width wp, and the string area ratio S2/S1 forms a gradation that gradually changes along the second direction. In plan view along the first direction, the string width ws is the width of each string 120 along the second direction. The inter-string region width wp is the width of each inter-string region 130 along the second direction. The string area ratio S2/S1 is the ratio of the area S2 of each string 120 to the total area S1 of each string 120 and the inter-string regions 130 adjacent to that string 120 in the second direction, in plan view seen along the first direction.

According to the above configuration, the first submodule 101 has a gradation along the second direction (Y-direction), which further enhances the design quality of the power generation module 1.

The plural submodules 100 may further include the third submodule 103 located on the side of the second submodule 102 opposite to the first submodule 101 in the second direction (Y-direction). The strings 120 of these submodules 101 to 103 may be configured, for example, as follows:

In each of the submodules 101 to 103, the plural strings 120 are arranged such that at least one of the string width ws, the inter-string region width wp, and the string area ratio S2/S1 gradually increases along the second direction. A gradation is formed from the submodule 101 across the submodule 102 to the submodule 103, in which at least one of the string width ws and the inter-string region width wp gradually increases along the second direction.

According to the above configuration, a gradation is formed in each of the submodules 101 to 103, and a gradation is also formed across the submodules 101 to 103. This allows the design quality of the power generation module 1 to be further enhanced.

The plural submodules 100 may further include the fourth submodule 104. The fourth submodule 104 is arranged adjacent to the first submodule 101 in the third direction (X-direction) intersecting the second direction (Y-direction) in plan view seen from the first direction (Z-direction). The plural strings 120 of the fourth submodule 104 may be arranged to form a gradation similar to that of the first submodule 101. This configuration makes it possible to form a gradation with a sense of unity over a wider range.

Furthermore, in this embodiment, the gradation is formed by laser processing the photovoltaic film. Thus, by changing the laser processing conditions (irradiation width, non-irradiation width), it is possible to separately fabricate submodules with a variety of gradations.

«Summary of Embodiments»

<1> A power generation module of the present disclosure is a power generation module comprising

a plurality of submodules, the plurality of submodules including a first submodule and a second submodule arranged adjacent to each other in plan view,
wherein each of the plurality of submodules comprises:

a base substrate; and
a power-generating section located on a portion of a main surface of the base substrate, the power-generating section comprising at least a photovoltaic layer supported on the main surface, and

wherein, in plan view, an area ratio of the power-generating section to the main surface in the first submodule is less than an area ratio of the power-generating section to the main surface in the second submodule.

<2> In the power generation module according to <1>, further comprising:

a first substrate having light-transmitting properties; and
a second substrate having light-transmitting properties and facing the first substrate in a first direction,
wherein the plurality of submodules are located between the first substrate and the second substrate.

<3> In the power generation module according to <1> or <2>, wherein a visible light transmittance of the first submodule is greater than a visible light transmittance of the second submodule.

<4> In the power generation module according to any one of <1> to <3>, wherein in each of the first submodule and the second submodule, the power-generating section comprises a plurality of strings supported on the main surface of the base substrate, each of the plurality of strings being a solar cell element string comprising a plurality of solar cell elements connected in series, and each of the plurality of strings extending, in plan view, from one end side to the other end side of the base substrate.

<5> In the power generation module according to <4>, wherein

the first submodule and the second submodule are adjacent to each other in a second direction in plan view, wherein each of the first submodule and the second submodule further comprises:

a first wiring arranged on the one end side of the base substrate; and
a second wiring arranged on the other end side of the base substrate, and

wherein, in each of the first submodule and the second submodule, the plurality of strings are spaced apart from one another in the second direction, each of the plurality of strings extending from the first wiring to the second wiring in a third direction intersecting the second direction.

<6> In the power generation module according to <5>, wherein
in at least one of the first submodule and the second submodule, the plurality of strings are arranged at equal intervals in the second direction in plan view
<7> In the power generation module according to any one of <1> to <6>, wherein

the first submodule and the second submodule are adjacent to each other in a second direction in plan view, wherein the plurality of submodules further include a third submodule, the third submodule being located on the side of the second submodule opposite to the first submodule in the second direction, and
wherein, in plan view, the area ratio of the power-generating section to the main surface in the second submodule is less than an area ratio of the power-generating section to the main surface in the third submodule.

<8> In the power generation module according to any one of <1> to <6>, wherein

the first submodule and the second submodule are adjacent to each other in a second direction in plan view, wherein the plurality of submodules further include a fourth submodule, the fourth submodule being adjacent to the first submodule in a third direction intersecting the second direction in plan view, and
wherein, in plan view, an area ratio of the power-generating section to the main surface in the fourth submodule is equal to the area ratio of the power-generating section to the main surface in the first submodule.

<9> In the power generation module according to <5>or <6>, wherein

in each of the plurality of submodules, the main surface of the base substrate includes a plurality of inter-string regions each located between two adjacent strings, and
wherein, in plan view, the plurality of strings in the first submodule are spaced apart from one another in the second direction so as to form a gradation in which at least one of a string width and an inter-string region width gradually changes along the second direction, the string width being a width of each string along the second direction in plan view, and the inter-string region width being a width of each inter-string region along the second direction in plan view.

<10> In the power generation module according to <5>or <6>, wherein

in the plurality of submodules, the main surface of the base substrate includes a plurality of inter-string regions each located between two adjacent strings, and
wherein, in plan view, the plurality of strings in the first submodule are spaced apart from one another in the second direction so as to form a gradation in which a string area ratio gradually changes along the second direction, the string area ratio being an area ratio of each string to a total area of the string and an inter-string region adjacent to the string in the second direction in plan view.

<11> In the power generation module according to <9>, wherein

the plurality of submodules further include a third submodule located on the side of the second submodule opposite to the first submodule in the second direction, and
wherein, in plan view, the plurality of strings in each of the first submodule, the second submodule, and the third submodule are arranged such that at least one of the string width and the inter-string region width gradually increases along the second direction, and form a gradation in which at least one of the string width and the inter-string region width gradually increases along the second direction from the first submodule through the second submodule to the third submodule.

<12> In the power generation module according to <10>, wherein

the plurality of submodules further include a third submodule located on the side of the second submodule opposite to the first submodule in the second direction, and
wherein, in plan view, the plurality of strings in each of the first submodule, the second submodule, and the third submodule are arranged such that the string area ratio gradually increases along the second direction, and form a gradation in which the string area ratio gradually increases along the second direction from the first submodule through the second submodule to the third submodule.

<13> In the power generation module according to <9> or <10>, wherein

the plurality of submodules further include a fourth submodule, the fourth submodule being adjacent to the first submodule in a third direction intersecting the second direction in plan view, and
wherein the plurality of strings of the fourth submodule are arranged to form a gradation similar to the gradation of the first submodule.

<14> In the power generation module according to any one of <1> to <13>, wherein
the first submodule and the second submodule are connected in parallel.
<15> In the power generation module according to any one of <1> to <14>, comprising
a plurality of module columns, each module column including at least the first submodule and the second submodule and extending in the second direction in plan view, wherein the plurality of module columns are arranged in a third direction intersecting the second direction and connected in series.
<16> In the power generation module according to any one of <1> to <15>, wherein
the photovoltaic layer comprises a perovskite compound.
<17> A method for manufacturing a power generation module of the present disclosure is a method for manufacturing a power generation module comprising a plurality of submodules, the plurality of submodules including a first submodule and a second submodule, the method comprising:

forming the plurality of submodules; and
arranging the first submodule and the second submodule adjacent to each other,
wherein the forming of the plurality of submodules comprises:

forming a laminated film including a photovoltaic film on a main surface of a base substrate; and
processing the laminated film to form a power-generating section including a photovoltaic layer on a part of the main surface,

wherein, in the processing of the laminated film, a portion of the photovoltaic film is removed from the main surface, and a remaining portion of the photovoltaic film forms the photovoltaic layer of the power-generating section, and
wherein a ratio of an area of the photovoltaic film removed in the processing of the laminated film to an area of the main surface differs between the first submodule and the second submodule.

<18> In the method for manufacturing a power generation module according to <17>, further comprising
bonding a first substrate having light-transmitting properties and a second substrate having light-transmitting properties to each other, with the plurality of submodules interposed between the first and second substrates, the first substrate and the second substrate facing each other in a first direction.
<19> In the method for manufacturing a power generation module according to <17> or <18>, wherein

the photovoltaic film comprises a perovskite compound,
wherein the forming of the laminated film includes forming the photovoltaic film by coating, and
wherein, in the processing of the laminated film, a plurality of strings are formed as the power-generating section, the processing of the laminated film including forming a plurality of the photovoltaic layers by laser processing the photovoltaic film, each of the plurality of photovoltaic layers forming a respective one of the plurality of strings.

<20> In the method for manufacturing a power generation module according to any one of <17> to <19>, wherein

each of the plurality of strings is a solar cell element string comprising a plurality of solar cell elements connected in series, and

wherein, in plan view, the plurality of strings of the first submodule and the second submodule extend parallel to each other from one end side to the other end side of the base substrate.

<21> In the method for manufacturing a power generation module according to any one of <17> to <20>, wherein

the first submodule and the second submodule are adjacent to each other in a second direction in plan view, wherein the plurality of submodules further include a third submodule, the third submodule being disposed on the side of the second submodule opposite to the first submodule in the second direction, and wherein the ratio of the area of the photovoltaic film removed in the processing of the laminated film to the area of the main surface differs among the first submodule, the second submodule, and the third submodule.

<22> In the method for manufacturing a power generation module according to any one of <17> to <21>, wherein

the first submodule and the second submodule are adjacent to each other in a second direction in plan view, wherein the plurality of submodules further include a fourth submodule, the fourth submodule being adjacent to the first submodule in a third direction intersecting the second direction in plan view, and wherein the ratio of the area of the photovoltaic film removed in the processing of the laminated film to the area of the main surface is the same for the first submodule and the fourth submodule.

<23> In the method for manufacturing a power generation module according to <22>, wherein in plan view, each of the plurality of strings of the first submodule is aligned in a straight line in the third direction with a corresponding one of the plurality of strings of the fourth submodule.
<24> In the method for manufacturing a power generation module of <17>,

three or more submodules each having a different power-generating section area ratio are arranged in a second direction (Y-direction), or
a fourth submodule having a power-generating section area ratio equal to that of the first submodule is disposed in a direction (third direction) orthogonal to the second module with respect to the first submodule, or
the strings of adjacent submodules in a first direction (X-direction) are aligned, and for example, the strings of the first submodule and the strings of the fourth submodule are aligned (substantially in a straight line) in a transverse direction.

INDUSTRIAL APPLICABILITY

The power generation module according to the present disclosure is useful as a power generation module applicable to building-integrated photovoltaics, for example, windows of buildings such as power generating glass.

REFERENCE SIGNS LIST

| | |
|---|---|
| 1 | power generation module |
| 11 | first substrate |
| 11s | first surface |
| 12 | second substrate |
| 13 | central region |
| 21, 22 | lead wire |
| 31 | first filler |
| 32 | second filler |
| 41, 41a to 41c | first wiring |
| 42, 42a to 42c | second wiring |
| 43 | third wiring |
| 50 | sealing member |
| 100 | submodule |
| 101 | first submodule |
| 102 | second submodule |
| 103 | third submodule |
| 104 | fourth submodule |

| 110 | base substrate |
|---|---|
| 110s | main surface of base substrate |
| 120 | string |
| 130 | inter-string region |
| 141, 142 | wiring |
| 150 | solar cell element |
| 151 | lower transparent electrode |
| 153 | semiconductor layer |
| 155 | upper transparent electrode |
| 160 | isolation groove |
| 170 | laminated film |
| LB | laser beam |
| LE | lower transparent conductive layer |
| PV | photovoltaic layer |
| UE | upper transparent conductive layer |
| pt, pt1 to pt3 | array pitch |
| R1 to R4 | module row |
| Ra to Rc | module column |
| ws | string width |
| wp | inter-string region width |
| wL, wL1, wL2 | irradiation width |
| wT, wT1, wT2 | non-irradiation width |

**Claims**

1. A power generation module comprising

   a plurality of submodules, the plurality of submodules including a first submodule and a second submodule arranged adjacent to each other in plan view,
   wherein each of the plurality of submodules comprises:

      a base substrate; and
      a power-generating section located on a portion of a main surface of the base substrate, the power-generating section comprising at least a photovoltaic layer supported on the main surface, and

   wherein, in plan view, an area ratio of the power-generating section to the main surface in the first submodule is less than an area ratio of the power-generating section to the main surface in the second submodule.

2. The power generation module according to claim 1, further comprising:

      a first substrate having light-transmitting properties; and
      a second substrate having light-transmitting properties and facing the first substrate in a first direction,
      wherein the plurality of submodules are located between the first substrate and the second substrate.

3. The power generation module according to claim 1 or 2, wherein
   a visible light transmittance of the first submodule is greater than a visible light transmittance of the second submodule.

4. The power generation module according to claim 1 or 2, wherein
   in each of the first submodule and the second submodule, the power-generating section comprises a plurality of strings supported on the main surface of the base substrate, each of the plurality of strings being a solar cell element string comprising a plurality of solar cell elements connected in series, and each of the plurality of strings extending, in plan view, from one end side to the other end side of the base substrate.

5. The power generation module according to claim 4, wherein

      the first submodule and the second submodule are adjacent to each other in a second direction in plan view,
      wherein each of the first submodule and the second submodule further comprises:

a first wiring arranged on the one end side of the base substrate; and
a second wiring arranged on the other end side of the base substrate, and

wherein, in each of the first submodule and the second submodule, the plurality of strings are spaced apart from one another in the second direction, each of the plurality of strings extending from the first wiring to the second wiring in a third direction intersecting the second direction.

6. The power generation module according to claim 5, wherein
in at least one of the first submodule and the second submodule, the plurality of strings are arranged at equal intervals in the second direction in plan view.

7. The power generation module according to claim 1 or 2, wherein

the first submodule and the second submodule are adjacent to each other in a second direction in plan view,
wherein the plurality of submodules further include a third submodule, the third submodule being located on the side of the second submodule opposite to the first submodule in the second direction, and
wherein, in plan view, the area ratio of the power-generating section to the main surface in the second submodule is less than an area ratio of the power-generating section to the main surface in the third submodule.

8. The power generation module according to claim 1 or 2, wherein

the first submodule and the second submodule are adjacent to each other in a second direction in plan view,
wherein the plurality of submodules further include a fourth submodule, the fourth submodule being adjacent to the first submodule in a third direction intersecting the second direction in plan view, and
wherein, in plan view, an area ratio of the power-generating section to the main surface in the fourth submodule is equal to the area ratio of the power-generating section to the main surface in the first submodule.

9. The power generation module according to claim 5, wherein

in each of the plurality of submodules, the main surface of the base substrate includes a plurality of inter-string regions each located between two adjacent strings, and
wherein, in plan view, the plurality of strings in the first submodule are spaced apart from one another in the second direction so as to form a gradation in which at least one of a string width and an inter-string region width gradually changes along the second direction, the string width being a width of each string along the second direction in plan view, and the inter-string region width being a width of each inter-string region along the second direction in plan view.

10. The power generation module according to claim 5, wherein

in the plurality of submodules, the main surface of the base substrate includes a plurality of inter-string regions each located between two adjacent strings, and
wherein, in plan view, the plurality of strings in the first submodule are spaced apart from one another in the second direction so as to form a gradation in which a string area ratio gradually changes along the second direction, the string area ratio being an area ratio of each string to a total area of the string and an inter-string region adjacent to the string in the second direction in plan view.

11. The power generation module according to claim 9, wherein

the plurality of submodules further include a third submodule located on the side of the second submodule opposite to the first submodule in the second direction, and
wherein, in plan view, the plurality of strings in each of the first submodule, the second submodule, and the third submodule are arranged such that at least one of the string width and the inter-string region width gradually increases along the second direction, and form a gradation in which at least one of the string width and the inter-string region width gradually increases along the second direction from the first submodule through the second submodule to the third submodule.

12. The power generation module according to claim 10, wherein

the plurality of submodules further include a third submodule located on the side of the second submodule opposite to the first submodule in the second direction, and

wherein, in plan view, the plurality of strings in each of the first submodule, the second submodule, and the third submodule are arranged such that the string area ratio gradually increases along the second direction, and form a gradation in which the string area ratio gradually increases along the second direction from the first submodule through the second submodule to the third submodule.

13. The power generation module according to claim 9, wherein

the plurality of submodules further include a fourth submodule, the fourth submodule being adjacent to the first submodule in a third direction intersecting the second direction in plan view, and

wherein the plurality of strings of the fourth submodule are arranged to form a gradation similar to the gradation of the first submodule.

14. The power generation module according to claim 1 or 2, wherein
the first submodule and the second submodule are connected in parallel.

15. The power generation module according to claim 1 or 2, comprising

a plurality of module columns, each module column including at least the first submodule and the second submodule and extending in the second direction in plan view,

wherein the plurality of module columns are arranged in a third direction intersecting the second direction and connected in series.

16. The power generation module according to claim 1 or 2, wherein
the photovoltaic layer comprises a perovskite compound.

17. A method for manufacturing a power generation module comprising a plurality of submodules, the plurality of submodules including a first submodule and a second submodule, the method comprising:

forming the plurality of submodules; and
arranging the first submodule and the second submodule adjacent to each other,
wherein the forming of the plurality of submodules comprises:

forming a laminated film including a photovoltaic film on a main surface of a base substrate; and
processing of the laminated film to form a power-generating section including a photovoltaic layer on a part of the main surface,

wherein, in the processing of the laminated film, a portion of the photovoltaic film is removed from the main surface, and a remaining portion of the photovoltaic film forms the photovoltaic layer of the power-generating section, and

wherein a ratio of an area of the photovoltaic film removed in the processing of the laminated film to an area of the main surface differs between the first submodule and the second submodule.

18. The method for manufacturing a power generation module according to claim 17, further comprising
bonding a first substrate having light-transmitting properties and a second substrate having light-transmitting properties to each other, with the plurality of submodules interposed between the first and second substrates, the first substrate and the second substrate facing each other in a first direction.

19. The method for manufacturing a power generation module according to claim 17 or 18, wherein

the photovoltaic film comprises a perovskite compound,
wherein the forming of the laminated film includes forming the photovoltaic film by coating, and
wherein, in the processing of the laminated film, a plurality of strings are formed as the power-generating section, the processing of the laminated film including forming a plurality of the photovoltaic layers by laser processing the photovoltaic film, each of the plurality of photovoltaic layers forming a respective one of the plurality of strings.

20. The method for manufacturing a power generation module according to claim 17 or 18, wherein

each of the plurality of strings is a solar cell element string comprising a plurality of solar cell elements connected in series, and

wherein, in plan view, the plurality of strings of the first submodule and the second submodule extend parallel to each other from one end side to the other end side of the base substrate.

21. The method for manufacturing a power generation module according to claim 17 or 18, wherein

the first submodule and the second submodule are adjacent to each other in a second direction in plan view, wherein the plurality of submodules further include a third submodule, the third submodule being disposed on the side of the second submodule opposite to the first submodule in the second direction, and

wherein the ratio of the area of the photovoltaic film removed in the processing of the laminated film to the area of the main surface differs among the first submodule, the second submodule, and the third submodule.

22. The method for manufacturing a power generation module according to claim 17 or 18, wherein

the first submodule and the second submodule are adjacent to each other in a second direction in plan view, wherein the plurality of submodules further include a fourth submodule, the fourth submodule being adjacent to the first submodule in a third direction intersecting the second direction in plan view, and

wherein the ratio of the area of the photovoltaic film removed in the processing of the laminated film to the area of the main surface is the same for the first submodule and the fourth submodule.

23. The method for manufacturing a power generation module according to claim 22, wherein
in plan view, each of the plurality of strings of the first submodule is aligned in a straight line in the third direction with a corresponding one of the plurality of strings of the fourth submodule.

# Fig. 1

Fig. 2

Fig. 3

1

12

32

11s

100

31

11

Z Y
X

## Fig. 4

## Fig. 5

Fig. 6A

Fig. 6B

Fig. 7

Fig. 8

## Fig. 9A

## Fig. 9B

Fig. 9C

Fig. 9D

Fig. 9E

Fig. 9F

Fig. 10A

Fig. 10B

Fig. 10C

## Fig. 11

## Fig. 12A

## Fig. 12B

Fig. 13A

Fig. 13B

Fig. 13C

Fig. 14

POWER-GENERATING
SECTION AREA RATIO (%)

100                                    0

100

LIGHT
TRANSMITTANCE
(%)

0

PHOTOVOLTAIC FILM REMOVAL
AREA RATIO (%)

100

Fig. 15

| STEP1 | SET LIGHT TRANSMITTANCE |
|---|---|
| STEP2 | SET TOTAL PHOTOVOLTAIC FILM REMOVAL AREA PER SUBMODULE |
| STEP3 | SET THE NUMBER OF STRINGS |
| STEP4 | SET AREA TO BE REMOVED PER SPOT (SET AREA OF INTER-STRING REGION) |
| STEP5 | SET DATA OF LASER PROCESSING MACHINE |

Fig. 16

Fig. 17

Fig. 18

Fig. 19A

Fig. 19B

Fig. 20

Fig. 21

Fig. 22

Fig. 23

Fig. 24

Fig. 25

Fig. 26

pt1>pt2>pt3
N1<N2<N3

Fig. 27

STRING AREA RATIO

VISIBLE LIGHT TRANSMITTANCE

FIRST SUBMODULE    SECOND SUBMODULE    THIRD SUBMODULE

DISTANCE ALONG Y-DIRECTION

Fig. 28A

Fig. 28B

Fig. 28C

Fig. 29A

Fig. 29B

Fig. 29C

(wT2>wT1)

## INTERNATIONAL SEARCH REPORT

| International application No. |
|---|
| **PCT/JP2024/025579** |

| A. | CLASSIFICATION OF SUBJECT MATTER |
|---|---|

*H10K 39/12*(2023.01)i; *H01L 31/05*(2014.01)i; *H01L 31/0468*(2014.01)i; *H10K 30/40*(2023.01)i
FI:   H10K39/12; H01L31/04 532C; H10K30/40; H01L31/04 570

According to International Patent Classification (IPC) or to both national classification and IPC

| B. | FIELDS SEARCHED |
|---|---|

Minimum documentation searched (classification system followed by classification symbols)

H01L31/04-31/078; H10K30/50-30/57; H10K39/10-39/18

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2002-299666 A (KANEGAFUCHI CHEM IND CO., LTD.) 11 October 2002 (2002-10-11)<br>paragraphs [0009]-[0031], fig. 1-5 | 1-23 |
| Y | JP 2013-4819 A (TAIYO KOGYO CORP.) 07 January 2013 (2013-01-07)<br>paragraphs [0013]-[0025], fig. 1-4 | 1-23 |
| Y | JP 2002-343998 A (SHARP KABUSHIKI KAISHA) 29 November 2002 (2002-11-29)<br>paragraphs [0023]-[0044], fig. 1-11 | 1-23 |
| Y | JP 2001-237449 A (SHARP KABUSHIKI KAISHA) 31 August 2001 (2001-08-31)<br>paragraphs [0006]-[0059], fig. 1-6 | 1-23 |
| Y | JP 2015-154049 A (MITSUBISHI CHEMICAL CORPORATION) 24 August 2015 (2015-08-24)<br>paragraphs [0011]-[0083], fig. 1-9 | 2, 18 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 August 2024** | **20 August 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/025579**

| Patent document cited in search report | | | Publication date (day/month/year) | Patent family member(s) | | | Publication date (day/month/year) |
|---|---|---|---|---|---|---|---|
| JP | 2002-299666 | A | 11 October 2002 | US paragraphs [0023]-[0045], fig. 1-5B EP | 2002/0139411 1246249 | A1 A2 | |
| JP | 2013-4819 | A | 07 January 2013 | (Family: none) | | | |
| JP | 2002-343998 | A | 29 November 2002 | (Family: none) | | | |
| JP | 2001-237449 | A | 31 August 2001 | (Family: none) | | | |
| JP | 2015-154049 | A | 24 August 2015 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020084640 A